(19)

Europäisches Patentamt

European Patent Office

Office européen des brevets

(11) **EP 4 699 846 A1**

(12) **EUROPEAN PATENT APPLICATION**

(43) Date of publication:
**25.02.2026  Bulletin 2026/09**

(21) Application number: **25172318.5**

(22) Date of filing: **24.04.2025**

(51) International Patent Classification (IPC):
**B60L 3/00** (2019.01)    **B60L 58/16** (2019.01)
**B60L 15/20** (2006.01)

(52) Cooperative Patent Classification (CPC):
**B60L 3/0046; B60L 15/20; B60L 58/16;**
B60L 2240/423; B60L 2240/547; B60L 2240/549;
B60L 2250/16

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **20.08.2024  KR 20240111412**

(71) Applicants:
• **Hyundai Motor Company**
  **Seoul 06797 (KR)**
• **Kia Corporation**
  **Seoul 06797 (KR)**

(72) Inventors:
• **BAEK, Yo Han**
  **18280 Hwaseong-si, Gyeonggido, (KR)**
• **CHOI, Yoon Sung**
  **18280 Hwaseong-si, Gyeonggido, (KR)**
• **LEE, Sang Jin**
  **18280 Hwaseong-si, Gyeonggido, (KR)**
• **LEE, Hyo Kyung**
  **18280 Hwaseong-si, Gyeonggido, (KR)**
• **JANG, Yoo Hong**
  **18280 Hwaseong-si, Gyeonggido, (KR)**

(74) Representative: **Viering, Jentschura & Partner mbB**
  **Patent- und Rechtsanwälte**
  **Am Brauhaus 8**
  **01099 Dresden (DE)**

(54) **APPARATUS FOR CONTROLLING VEHICLE AND METHOD THEREOF**

(57)    Disclosed are an apparatus for controlling a vehicle, and a method thereof. The apparatus includes a processor, memory, a battery comprising one or more battery cells, and a motor. The processor may be configured to disconnect, based on receiving a request for diagnosing the battery, the motor from a drive shaft; obtain, based on controlling the motor according to status information of the battery in a no-load state where the motor is disconnected from the drive shaft, one or more parameters that indicate an internal series resistance of each of the one or more battery cells; identify an abnormal battery cell, of the one or more battery cells, corresponding to a parameter, of the one or more parameters, that exceeds a threshold value; and control, based on the identifying of the abnormal battery cell, an operation of the vehicle.

VEHICLE CONTROL APPARATUS
100

| PROCESSOR 110 |
| MOTOR 130 |
| INVERTER 135 |
| BATTERY 140 |
| DISPLAY 145 |

MEMORY 120
PROFILE INFORMATION 121
BATTERY CELL INFORMATION 122

FIG.1A

**EP 4 699 846 A1**

Description

## CROSS-REFERENCE TO RELATED APPLICATION

This application claims k priority to Korean Patent Application No. 10-2024-0111412, filed in the Korean Intellectual Property Office on August 20, 2024, the entire contents of which are incorporated herein by reference.

## TECHNICAL FIELD

The present disclosure relates to an apparatus for controlling a vehicle and method thereof, and more particularly relates to a technique for diagnosing a battery.

## BACKGROUND

The internal series resistance of the battery cell of an electronic vehicle (EV) is a major monitoring target for pre-failure diagnosis, and various attempts have been made to monitor the internal series resistance. Diagnostic methods for internal series resistance include methods using vehicle driving data or rapid charging data, and the larger the amount of current and the greater the current change, the easier the operation may be. Measuring the internal series resistance using at least one of the methods described above may result in the inconvenience of having to drive the vehicle or perform a rapid charge. Additionally, when the current intensity and current change amount are small while the vehicle is driven or rapidly charged, it may be difficult or impossible to measure the internal series resistance. Therefore, there is a need for an improved method of measuring the internal series resistance of a battery cell that may not, for example, require the vehicle be driven and not require a rapid charging infrastructure.

## SUMMARY

The present disclosure has been made to solve the above-mentioned problems occurring in at least some implementations while advantages achieved by those implementations are maintained intact.

One aspect of the present disclosure provides an apparatus for controlling a vehicle capable of diagnosing the battery while the vehicle is stopped or parked and a method thereof.

Another aspect of the present disclosure provides an apparatus for controlling a vehicle capable of diagnosing the battery by disconnecting the connection between a motor and a drive shaft and a method thereof.

Still another aspect of the present disclosure provides an apparatus for controlling a vehicle capable of reconfirming abnormal battery cell information obtained while charging or driving the vehicle and a method thereof.

The technical problems to be solved by the present disclosure are not limited to the aforementioned problems, and any other technical problems not mentioned herein will be clearly understood from the following description by those skilled in the art to which the present disclosure pertains.

According to one or more example embodiments of the present disclosure, an apparatus for controlling a vehicle, the apparatus may include: a processor; memory; a battery including one or more battery cells; and a motor. The processor may be configured to: disconnect, based on receiving a request for diagnosing the battery, the motor from a drive shaft; obtain, based on controlling the motor according to status information of the battery in a no-load state where the motor is disconnected from the drive shaft, one or more parameters that indicate an internal series resistance of each of the one or more battery cells; identify an abnormal battery cell, of the one or more battery cells, corresponding to a parameter, of the one or more parameters, that exceeds a threshold value; and control, based on the identifying of the abnormal battery cell, an operation of the vehicle.

The processor may be configured to obtain the one or more parameters by: identifying a discharging current that is output from the battery while controlling, based on a torque according to the status information, the motor; obtaining a first voltage corresponding to the discharging current; and obtaining, based on at least one of the discharging current or the first voltage, first parameters, of the one or more parameters, that indicate an internal series resistance associated with the discharging current.

The processor may be configured to obtain the one or more parameters further by: after the controlling of the motor based on the torque, transmitting, to the battery, a charging current obtained while controlling, based on a counter torque according to the status information, the motor; obtaining a second voltage corresponding to the charging current; and based on at least one of the discharging current, the charging current, the first voltage, or the second voltage, obtaining second parameters, of the one or more parameters, that indicate an internal series resistance associated with the charging current.

The processor may be configured to identify the abnormal battery cell by: identifying, based on at least one of a standard deviation of the first parameters or a standard deviation of the second parameters, the parameter that exceeds the threshold value.

The processor may be configured to obtain the first voltage by: obtaining the first voltage that corresponds to a target value of the discharging current by increasing an amount of the discharging current.

The processor may be configured to obtain the second voltage by: obtaining the second voltage that corresponds to a target value of the charging current by increasing an amount of the charging current.

The processor may be configured to obtain the first parameters by: obtaining a no-load voltage of the battery before controlling the motor in the no-load state; and obtaining the first parameters based on the discharging current, the first voltage, and the no-load voltage.

The processor may be configured to obtain the one or more parameters by: obtaining the one or more parameters that correspond to a current target value by increasing a torque of the motor. Increasing the torque of the motor may be performed by controlling the motor based on the status information.

The apparatus may further include a display. The processor may be further configured to display, on the display, information about the abnormal battery cell.

The processor may be further configured to: before the receiving of the request for diagnosing the battery, obtain battery cell information of the battery; and determine whether the abnormal battery cell matches the battery cell information.

According to one or more example embodiments of the present disclosure, a method performed by an apparatus of a vehicle may include: disconnecting, based on receiving a request for diagnosing a battery of the vehicle, a motor of the vehicle from a drive shaft of the vehicle. The battery may include one or more battery cells; obtaining, based on controlling the motor according to status information of the battery in a no-load state where the motor is disconnected from the drive shaft, one or more parameters that indicate an internal series resistance of each of the one or more battery cells; identifying an abnormal battery cell, of the one or more battery cells, corresponding to a parameter, of the one or more parameters, that exceeds a threshold value; and controlling, based on the abnormal battery cell, an operation of the vehicle.

Obtaining the one or more parameters may include: identifying a discharging current that is output from the battery while controlling, based on a torque according to the status information, the motor; obtaining a first voltage corresponding to the discharging current; and obtaining, based on at least one of the discharging current or the first voltage, first parameters, of the one or more parameters, that indicate an internal series resistance associated with the discharging current.

Obtaining the one or more parameters may further include: after the controlling of the motor based on the torque, transmitting, to the battery, a charging current obtained while controlling, based on a counter torque according to the status information, the motor; obtaining a second voltage corresponding to the charging current; and, based on at least one of the discharging current, the charging current, the first voltage, or the second voltage, obtaining second parameters, of the one or more parameters, that indicate an internal series resistance associated with the charging current.

Identifying the abnormal battery cell may include: identifying, based on at least one of a standard deviation of the first parameters or a standard deviation of the second parameters, the parameter that exceeds the threshold value.

Obtaining the first voltage may include: obtaining the first voltage that corresponds to a target value of the discharging current by increasing an amount of the discharging current.

Obtaining the second voltage may include: obtaining the second voltage that corresponds to a target value of the charging current by increasing an amount of the charging current.

Obtaining the first parameters may include: obtaining a no-load voltage of the battery before controlling the motor in the no-load state; and obtaining the first parameters based on the discharging current, the first voltage, and the no-load voltage.

Obtaining the one or more parameters may include: obtaining the one or more parameters that correspond to a current target value by increasing a torque of the motor. Increasing the torque of the motor may be performed by controlling the motor based on the status information.

The method may further include: displaying, on a display of the vehicle, information about the abnormal battery cell.

According to one or more example embodiments of the present disclosure, a system for controlling a vehicle may include: a vehicle control unit (VCU); a motor controller unit (MCU); and a battery management unit (BMU). The VCU may be configured to, based on a request for diagnosing a battery, temporarily disengage a coupling between a motor and a drive shaft for transmitting power generated by the motor to a wheel. The battery may include one or more battery cells. The MCU may be configured to obtain a torque by controlling, in a no-load state where the coupling between the motor and the drive shaft is temporarily disengaged, the motor according to status information received from the BMU. The BMU may be configured to: transmit, to the VCU, the status information; identify: a current, of the battery, that corresponds to the torque, and a voltage, of the battery, that corresponds to the torque; obtain, based on the current and the voltage, one or more parameters that indicate an internal series resistance of each of the one or more battery cells; and identify an abnormal battery cell, of the one or more battery cells, corresponding to a parameter, of the one or more parameters, that exceeds a threshold value. At least one of the VCU, the MCU, or the BMU may be configured to control, based on the abnormal battery cell, an operation of the vehicle.

## BRIEF DESCRIPTION OF THE DRAWINGS

The above and other objects, features and advantages of the present disclosure will be more apparent from the following detailed description taken in conjunction with the accompanying drawings:

FIGS. 1A and 1B are block diagrams illustrating an example of an apparatus for controlling a vehicle; FIG. 2 is a flowchart illustrating an example of an operation of a system for controlling a vehicle;

FIG. 3 is a flowchart illustrating an example of an operation of initiating abnormal diagnosis of a battery by a system for controlling a vehicle;

FIG. 4 is a flowchart illustrating an example of an operation of controlling a motor to identify the internal series resistance of a battery by a system for controlling a vehicle;

FIG. 5 is a diagram illustrating an example of profile information for identifying the internal series resistance of a battery by a system for controlling a vehicle;

FIG. 6 is a flowchart illustrating an example of an operation of identifying an internal series resistance by a system for controlling a vehicle;

FIG. 7 is a flowchart illustrating an example of an operation of diagnosing an abnormal battery cell by a system for controlling a vehicle;

FIG. 8 is a flowchart illustrating an example of an operation of guiding an abnormal battery cell by a system for controlling a vehicle;

FIG. 9 is a flowchart illustrating an example of an operation of identifying an abnormal battery cell using previous diagnostic data by a system for controlling a vehicle;

FIG. 10 is a flowchart illustrating a method of controlling a vehicle; and

FIG. 11 is a block diagram illustrating a computing system related to an apparatus for controlling a vehicle or a method of controlling a vehicle.

## DETAILED DESCRIPTION

Hereinafter, one or more example embodiments of the present disclosure will be described in detail with reference to the exemplary drawings. In adding the reference numerals to the components of each drawing, it should be noted that the identical or equivalent component is specified by the identical numeral even when they are displayed on other drawings. Further, in describing the example embodiment of the present disclosure, a detailed description of the related known configuration or function will be omitted when it is determined that it interferes with the understanding of the example embodiment of the present disclosure.

In addition, terms, such as first, second, A, B, (a), (b) or the like may be used herein when describing components of the present disclosure. The terms are provided only to distinguish the elements from other elements, and the essences, sequences, orders, and numbers of the elements are not limited by the terms. In addition, unless defined otherwise, all terms used herein, including technical or scientific terms, have the same meanings as those generally understood by those skilled in the art to which the present disclosure pertains. The terms defined in the generally used dictionaries should be construed as having the meanings that coincide with the meanings of the contexts of the related technologies, and should not be construed as ideal or excessively formal meanings unless clearly defined in the specification of the present disclosure.

For purposes of this application and the claims, using the exemplary phrase "at least one of: A; B; or C" or "at least one of A, B, or C," the phrase means "at least one A, or at least one B, or at least one C, or any combination of at least one A, at least one B, and at least one C. Further, exemplary phrases, such as "A, B, and C", "A, B, or C", "at least one of A, B, and C", "at least one of A, B, or C", etc. as used herein may mean each listed item or all possible combinations of the listed items. For example, "at least one of A or B" may refer to (1) at least one A; (2) at least one B; or (3) at least one A and at least one B.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. The module may be implemented in a form of an application-specific integrated circuit (ASIC). Operations performed by the module, the program, or another component may be carried out sequentially, in parallel, or repeatedly, or one or more of the operations may be executed in a different order or omitted, or one or more other operations may be added.

An automation level of an autonomous driving vehicle may be classified as follows, according to the American Society of Automotive Engineers (SAE). At autonomous driving level 0, the SAE classification standard may correspond to "no automation," in which an autonomous driving system is temporarily involved in emergency situations (e.g., automatic emergency braking) and/or provides warnings only (e.g., blind spot warning, lane departure warning, etc.), and a driver is expected to operate the vehicle. At autonomous driving level 1, the SAE classification standard may correspond to "driver assistance," in which the system performs some driving functions (e.g., steering, acceleration, brake, lane centering, adaptive cruise control, etc.) while the driver operates the vehicle in a normal operation section, and the driver is expected to determine an operation state and/or timing of the system, perform other driving functions, and cope with (e.g., resolve) emergency situations. At autonomous driving level 2, the SAE classification standard may correspond to "partial automation," in which the system performs steering, acceleration, and/or braking under the supervision of the driver, and the driver is expected to determine an operation state and/or timing of the system, perform other driving functions, and cope with (e.g., resolve) emergency situations. At autonomous driving level 3, the SAE classification standard may correspond to "conditional automation," in which the system drives the vehicle (e.g., performs driving functions such as steering, acceleration, and/or braking) under limited conditions but transfer driving control to the driver when the required conditions are not met, and the driver is expected to determine an operation state and/or timing of the system, and take over control in emergency situations but do not otherwise operate the vehicle (e.g., steer, accelerate, and/or brake). At autonomous driving level 4, the SAE classification standard may correspond to "high automation," in which the system performs all driving functions, and the driver is expected to take control of the vehicle only in emergency situations. At autonomous driving level 5, the SAE classification standard may correspond to "full automation," in which the system performs full driving functions without any aid from the driver including in emergency situations, and the driver is not expected to perform any driving functions other than determining the operating state of the system. Although the present disclosure may apply the SAE classification standard for autonomous driving classification, other classification methods and/or algorithms may be used in one or more configurations described herein. One or more features associated with autonomous driving control may be activated based on configured autonomous driving control setting(s) (e.g., based on at least one of: an autonomous driving classification, a selection of an autonomous driving level for a vehicle, etc.).

Based on one or more features (e.g., identifying an abnormal battery) described herein, an operation of the vehicle may be controlled. The vehicle control may include various operational controls associated with the vehicle (e.g., autonomous driving control, sensor control, braking control, braking time control, acceleration control, acceleration change rate control, alarm timing control, forward collision warning time control, etc.).

One or more auxiliary devices (e.g., engine brake, exhaust brake, hydraulic retarder, electric retarder, regenerative brake, etc.) may also be controlled, for example, based on one or more features (e.g., identifying an abnormal battery) described herein. One or more communication devices (e.g., a modem, a network adapter, a radio transceiver, an antenna, etc., that is capable of communicating via one or more wired or wireless communication protocols, such as Ethernet, Wi-Fi, near-field communication (NFC), Bluetooth, Long-Term Evolution (LTE), 5G New Radio (NR), vehicle-to-everything (V2X), etc.) may also be controlled, for example, based on one or more features (e.g., identifying an abnormal battery) described herein.

Minimum risk maneuver (MRM) operation(s) may also be controlled, for example, based on one or more features (e.g., identifying an abnormal battery) described herein. A minimal risk maneuvering operation (e.g., a minimal risk maneuver, a minimum risk maneuver) may be a maneuvering operation of a vehicle to minimize (e.g., reduce) a risk of collision with surrounding vehicles in order to reach a lowered (e.g., minimum) risk state. A minimal risk maneuver may be an operation that may be activated during autonomous driving of the vehicle when a driver is unable to respond to a request to intervene. During the minimal risk maneuver, one or more processors of the vehicle may control a driving operation of the vehicle for a set period of time.

Biased driving operation(s) may also be controlled, for example, based on one or more features (e.g., identifying an abnormal battery) described herein. A driving control apparatus may perform a biased driving control. To perform a biased driving, the driving control apparatus may control the vehicle to drive in a lane by maintaining a lateral distance between the position of the center of the vehicle and the center of the lane. For example, the driving control apparatus may control the vehicle to stay in the lane but not in the center of the lane.

The driving control apparatus may identify a biased target lateral distance for biased driving control. For example, a biased target lateral distance may include an intentionally adjusted lateral distance that a vehicle may aim to maintain from a reference point, such as the center of a lane or another vehicle, during maneuvers such as lane changes. This adjustment may be made to improve the vehicle's stability, safety, and/or performance under varying driving conditions, etc. For example, during a lane change, the driving control system may bias the lateral distance to keep a safer gap from adjacent vehicles, considering factors such as the vehicle's speed, road conditions, and/or the presence of obstacles, etc.

One or more sensors (e.g., IMU sensors, camera, LIDAR, RADAR, blind spot monitoring sensor, line departure warning sensor, parking sensor, light sensor, rain sensor, traction control sensor, anti-lock braking system sensor, tire pressure monitoring sensor, seatbelt sensor, airbag sensor, fuel sensor, emission sensor, throttle position sensor, inverter, converter, motor controller, power distribution unit, high-voltage wiring and connectors, auxiliary power modules, charging interface, etc.) may also be controlled, for example, based on one or more features (e.g., identifying an abnormal battery) described herein.

An operation control for autonomous driving of the vehicle may include, for example, alert notification, balancing actions, and/or reduced power output. Additionally, an operation control for autonomous driving of the vehicle may include various driving control of the vehicle by the vehicle control device (e.g., acceleration, deceleration, steering control, gear shifting control, braking system control, traction control, stability control, cruise control, lane keeping assist control, collision avoidance system control, emergency brake assistance control, traffic sign recognition control, adaptive headlight control, etc.).

Various example embodiments as set forth herein may be implemented as software (e.g., program) including one or more instructions that are stored in a storage medium (e.g., internal memory or external memory) that is readable by a machine (e.g., an apparatus 100 for controlling a vehicle). For example, a processor (e.g., a processor 110) of the machine (e.g., the apparatus 100 for controlling a vehicle) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

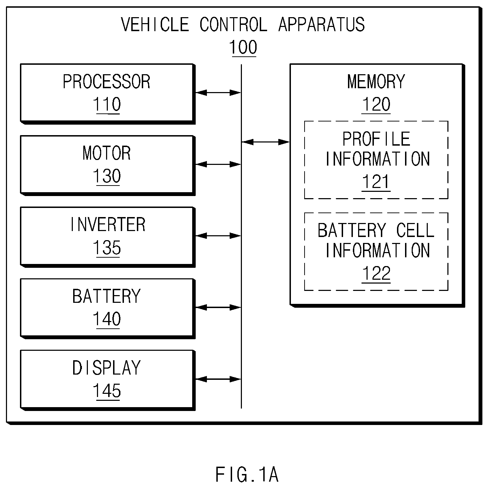

Hereinafter, one or more example embodiments of the present disclosure will be described in detail with reference to FIGS. 1A to 11.

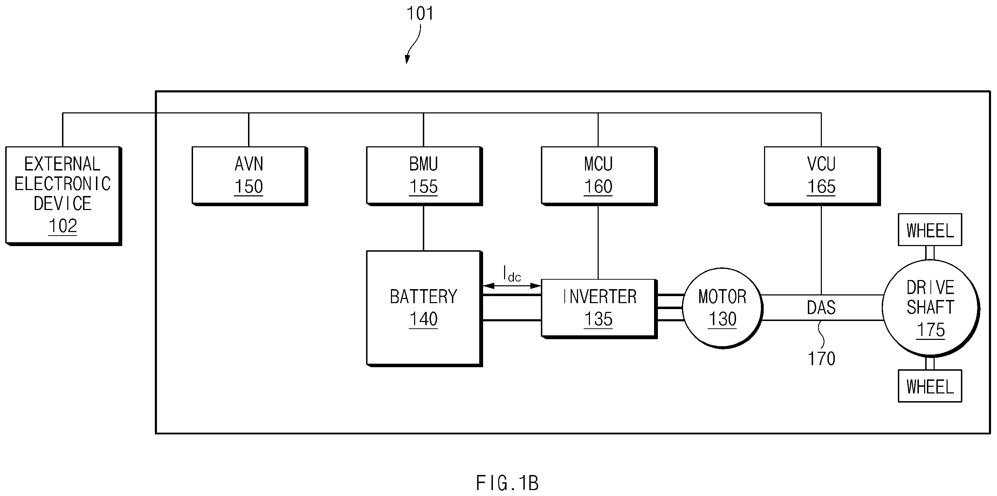

FIGS. 1A and 1B are block diagrams illustrating an example of an apparatus for controlling a vehicle.

Referring to FIG. 1A, the apparatus 100 for controlling a vehicle may be implemented inside or outside a vehicle, and some of the components included in the apparatus 100 for controlling a vehicle may be implemented inside or outside the vehicle. In this case, the apparatus 100 for controlling a vehicle may be formed integrally with internal control devices of the vehicle, or may be implemented as a separate device and connected to the control devices of the vehicle through a separate connection device. For example, the apparatus 100 for controlling a vehicle may further include components not shown in FIG. 1A

Referring to FIG. 1A, the apparatus 100 for controlling a vehicle may include at least one of the processor 110, a memory 120, a motor 130, an inverter 135, a battery 140, or a display 145. The processor 110, the memory 120, the motor 130, the inverter 135, the battery 140, and the display 145 may be electrically and/or operably coupled with each other through electronic components including a communication bus. Hereinafter, hardware being operably coupled may mean that a direct connection or an indirect connection between the hardware is established wired or wirelessly, such that second hardware is controlled by first hardware among the hardware. Although shown based on different blocks, the present disclosure is not limited thereto, and some of the hardware in FIG. 1A (e.g., at least a portion of the processor 110, the memory 120, and communication circuit (not shown)) may be included in a single integrated circuit such as a system-on-chip (SoC).

The apparatus 100 for controlling a vehicle may be an example of a central processing unit for managing a plurality of control units within a vehicle.

The processor 110 of the apparatus 100 for controlling a vehicle may include a hardware component for processing data based on one or more instructions. For example, hardware components for processing data may include an arithmetic and logic unit (ALU), a floating point unit (FPU), a field programmable gate array (FPGA), a central processing unit (CPU), a micro controller unit (MCU), and/or an application processor (AP). The number of processors 110 may be one or more. For example, the processor 110 may have the structure of a multi-core processor including dual cores, quad cores, hexa cores, or octa cores.

The memory 120 of the apparatus 100 for controlling a vehicle may include a hardware component for storing data and/or instructions input and/or output to the processor 110. For example, the memory 120 may include a volatile memory such as a random-access memory (RAM) and/or a non-volatile memory such as a read-only memory (ROM). For example, the volatile memory may include at least one of a dynamic RAM (DRAM), a static RAM (SRAM), a cache RAM, and a pseudo SRAM (PSRAM). For example, the non-volatile memory may include at least one of a programmable ROM (PROM), an erasable PROM (EPROM), an electrically erasable PROM (EEPROM), a flash memory, a hard disk, a compact disk, and an embedded multi-media card (eMMC).

The battery 140 of the apparatus 100 for controlling a vehicle may include a battery pack, a battery cell, and/or a battery module. For example, the battery pack may include one or more unit cells. For example, the battery module may include one or more battery cells. For example, a battery cell may include a positive electrode, a negative electrode, and an electrolyte. For example, a battery pack may include a battery cell, a battery module, a battery management system (BMS), and/or a cooling system.

For example, the battery 140 may be one of a lithium ion (Li-ion) battery, a lithium ion (Li-ion) polymer battery, a lead storage battery, a nickel-cadmium (Ni-Cd) battery, or a nickel metal hydride (NiMH) battery. However, the operation performed by the apparatus 100 for controlling a vehicle may be performed independently of the chemical properties of the battery 140. The battery 140 may supply electricity to a motor in an electric vehicle (EV) mode and a hybrid electric vehicle (HEV) mode of the vehicle, and may be charged with electricity recovered through the motor in a regenerative braking mode.

The apparatus 100 for controlling a vehicle may drive the motor 130 by controlling the inverter 135 using a current or power related to the battery 140. The apparatus 100 for controlling a vehicle may control the vehicle based on driving the motor 130. Information about the current or power related to the battery 140 may be included in profile information 121. The profile information 121 may be referred to as status information in terms of indicating the status of a battery.

For example, the apparatus 100 for controlling a vehicle may drive the motor 130 based on a torque by controlling the inverter 135. The direction of the torque and the direction of the counter torque may be opposite.

For example, the apparatus 100 for controlling a vehicle may drive the motor 130 based on the counter torque by controlling the inverter 135.

For example, the operation of driving the motor 130 based on the counter torque may include an operation for reducing the torque of the motor driven based on the torque. In other words, the operation of driving the motor 130 based on the counter torque may include an operation of controlling the inverter 135 to increase the counter torque. By increasing the counter torque, the torque of the motor 130 may be reduced.

The motor 130 may include a motor reducer. For example, the operation by which the apparatus 100 controls the inverter 135 to drive the motor 130 based on the counter torque may include an operation of reducing the torque of the motor 130 by obtaining the counter torque using the motor reducer, but the present disclosure is not limited thereto.

For example, the current required to drive the motor 130 based on the torque by controlling the inverter 135 by the apparatus 100 for controlling a vehicle may be referred to as a discharging current.

For example, the current obtained based on the rotational power (or electromotive force) of the motor 130 while the apparatus 100 for controlling a vehicle drives the motor 130 based on the counter torque by controlling the inverter 135 may be referred to as a charging current. For example, the apparatus 100 for controlling a vehicle may transmit (e.g., apply) the current obtained based on the rotational power of the motor 130 to the battery 140. In terms of the transmission of the current from the motor 130 to the battery 140, the current may include a charging current.

The apparatus 100 for controlling a vehicle may provide an environment similar to a phenomenon in which a charging current is obtained based on regenerative braking by the rotational force of the motor when the motor 130 is driven based on a counter torque by controlling the inverter 135. The apparatus 100 for controlling a vehicle may reduce the rotation speed of the motor 130 by controlling the inverter 135 to increase the counter torque.

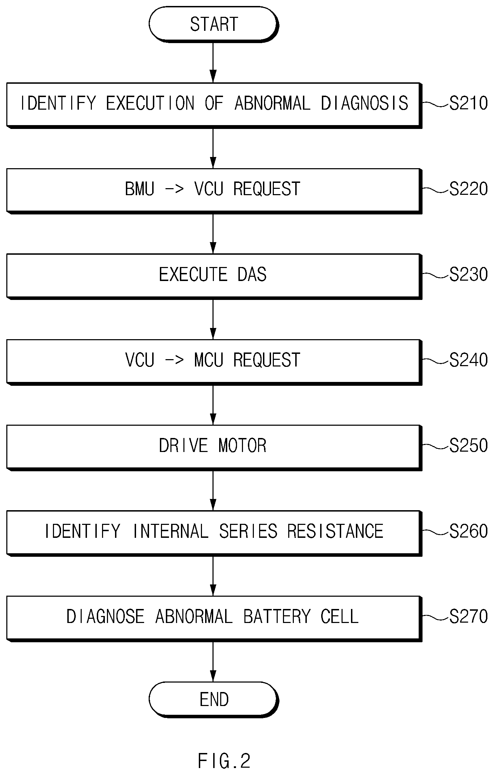

In the memory 120 of the apparatus 100 for controlling a vehicle, one or more instructions (or commands) representing calculations and/or operations to be performed on data by the processor 110 may be stored. A set of one or more instructions may be referred to as firmware, an operating system, a process, a routine, a sub-routine and/or an application. For example, the apparatus 100 for controlling a vehicle and/or processor 110 may perform at least one among operations of FIGS. 2 to 4 and 6 to 10 when executing a set of a plurality of instructions distributed in the form of an operating system, firmware, a driver, and/or an application.

The apparatus 100 for controlling a vehicle may disconnect the connection between the motor 130 and a drive shaft in response to an input for diagnosing the battery 140. The input may be, for example, a request, a command, or an instruction. The input may, for example, be a user input received via a user interface of the vehicle, such as an audio video navigation (AVN) system.

For example, an input for diagnosing the battery 140 may include an input for identifying the internal series resistances of one or more battery cells included in the battery 140. The input for diagnosing the battery 140 may include an input for identifying an abnormal battery cell using the internal series resistances of one or more battery cells.

For example, the apparatus 100 for controlling a vehicle may receive the input for diagnosing the battery 140 from an external electronic device after the vehicle is parked or stopped.

For example, the apparatus 100 for controlling a vehicle may diagnose the state of the battery by disconnecting at least one of the connection between the drive shaft corresponding to the front wheels and the motor or the connection between the drive shaft corresponding to the rear wheels and the motor while the vehicle is driven. In other words, the vehicle may disconnect the motor from the drive shaft (e.g., the drive shaft for the front wheels or the rear wheels).

For example, the external electronic device may include a diagnostic tool for diagnosing a vehicle or an external cloud server for identifying information about a vehicle.

For example, the apparatus 100 for controlling a vehicle may disconnect the connection between the motor 130 and the drive shaft such that the power (or rotational force) of the motor 130 is not transmitted to the wheels of the vehicle. For example, the apparatus 100 for controlling a vehicle may disconnect the connection between the motor 130 and the drive shaft based on the execution of a disconnector actuator system (DAS) or an all-wheel drive (AWD) disconnector system, but the present disclosure is not limited thereto.

The apparatus 100 for controlling a vehicle may obtain one or more parameters representing (e.g., indicating) an internal series resistance of each of one or more battery cells included in the battery 140, based on controlling the motor 130 according to profile information related to the battery 140 in a no-load state where the connection between the motor 130 and the drive shaft is disconnected. The current may include a discharging current for driving the motor 130 and/or a charging current obtained based on the rotational power of the motor 130.

The apparatus 100 for controlling a vehicle may obtain one or more parameters corresponding to a current target value (e.g., maximum value) by increasing the torque of the motor 130 based on controlling the motor 130 using the profile information 121 for diagnosing the internal series resistance. The target value may include a maximum value, a minimum value, or a set value of the current.

For example, the profile information 121 may include information about the performance of the motor 130 (e.g., maximum or minimum torque), the performance of the battery 140 (e.g., maximum charging current, maximum discharging current, maximum power, and/or voltage), and/or the performance of the inverter 135. The profile information 121 may include information about rounds per minute (RPM) obtainable through the motor 130 and the temperature of the motor.

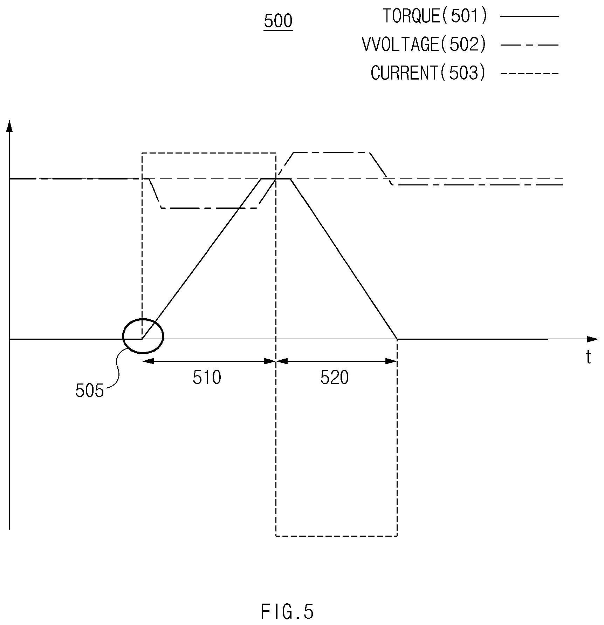

For example, the profile information 121 may be represented as in a graph 500 of FIG. 5 described below.

The apparatus 100 for controlling a vehicle may determine at least one battery cell corresponding to at least one parameter exceeding a specified threshold among one or more parameters as an abnormal battery cell.

The apparatus 100 for controlling a vehicle may identify the current output from the battery 140 as a discharging current by controlling the motor 130 based on the torque. For example, the apparatus 100 for controlling a vehicle may identify the internal series resistance to the discharging current.

The apparatus 100 for controlling a vehicle may obtain a first voltage corresponding to the discharging current.

The apparatus 100 for controlling a vehicle may obtain the first voltage corresponding to a target value of a discharging current by increasing the amount of the discharging current.

For example, the apparatus 100 for controlling a vehicle may increase the amount of the discharging current relatively quickly to obtain the internal series resistance. Because the vehicle must be driven or rapidly charged to obtain the internal series resistance, the apparatus 100 for controlling a vehicle may provide a virtual environment such as driving a vehicle by relatively quickly increasing the amount of the discharging current in a no-load state.

For example, a no-load state may indicate a state in which the connection between the motor 130 and the drive shaft is disconnected.

For example, the apparatus 100 for controlling a vehicle may represent a virtual environment in which a vehicle is driven at a high speed or accelerated rapidly by relatively quickly increasing the amount of the discharging current in a no-load state.

For example, the apparatus 100 for controlling a vehicle may obtain first parameters representing the internal series resistance for the discharging current among one or more parameters by using the discharging current and the first voltage.

For example, the apparatus 100 for controlling a vehicle may obtain a no-load voltage of the battery 140 before controlling the motor 130 in a no-load state. For example, the apparatus 100 for controlling a vehicle may obtain the no-load voltage of each of one or more battery cells included in the battery. The apparatus 100 for controlling a vehicle may obtain the first parameters by using the discharging current, the first voltage, and/or the no-load voltage.

The apparatus 100 for controlling a vehicle may determine an abnormal battery cell by using the standard deviation of the first parameters.

For example, the apparatus 100 for controlling a vehicle may use the standard deviation of the first parameters to identify at least one parameter that exceeds a specified threshold (e.g., 3 sigma). The apparatus 100 for controlling a vehicle may determine at least one battery cell corresponding to at least one parameter as an abnormal battery cell.

For example, the apparatus 100 for controlling a vehicle may identify at least one parameter that exceeds the specified threshold without using the standard deviation of the first parameters. For example, the apparatus 100 for controlling a vehicle may identify at least one parameter that exceeds the specified threshold value, which represents a preset reference value before vehicle mass production. For example, the apparatus 100 for controlling a vehicle may identify at least one parameter that exceeds the specified threshold representing a preset reference value using data collected after vehicle mass production.

For example, the apparatus 100 for controlling a vehicle may identify at least one battery cell determined as an abnormal battery cell as a discharging series resistance abnormal battery cell by controlling the motor 130 based on the torque.

The apparatus 100 for controlling a vehicle may identify a charging current by controlling the motor 130 based on the identified counter torque by controlling the inverter. For example, the apparatus 100 for controlling a vehicle may control the motor 130 by using the discharging current output from the battery 140, and then temporarily refrain from outputting the discharging current from the battery 140. The apparatus 100 for controlling a vehicle may obtain the charging current based on the rotational power of the motor 130 obtained based on the discharging current. The apparatus 100 for controlling a vehicle may transmit (e.g., apply) the obtained charging current to the battery through the inverter.

The apparatus 100 for controlling a vehicle may obtain a second voltage corresponding to the charging current transmitted (e.g., applied) to the battery.

For example, the apparatus 100 for controlling a vehicle may provide a virtual environment such as performing rapid charging by relatively rapidly increasing the amount of the charging current. However, the present disclosure is not limited thereto.

For example, the apparatus 100 for controlling a vehicle may obtain the second voltage corresponding to the target value of the charging current by increasing the amount of the charging current.

The apparatus 100 for controlling a vehicle may obtain second parameters representing the internal series resistance for the charging current among one or more parameters by using at least one of the discharging current, the charging current, the first voltage, or the second voltage, or any combination thereof.

The apparatus 100 for controlling a vehicle may identify at least one parameter exceeding the specified threshold (e.g., 3 sigma) by using the standard deviation of the second parameters. For example, the apparatus 100 for controlling a vehicle may determine at least one battery cell corresponding to at least one parameter as an abnormal battery cell.

For example, the apparatus 100 for controlling a vehicle may identify at least one battery cell determined as an abnormal battery cell as a charging series resistance abnormal battery cell by controlling the inverter to control the motor 130 based on the counter torque.

For example, the apparatus 100 for controlling a vehicle may identify the maximum charging current by increasing the counter torque. The apparatus 100 for controlling a vehicle may identify at least one battery cell determined as an abnormal battery cell for the maximum charging current as a battery cell with an abnormal charging series resistance.

The apparatus 100 for controlling a vehicle may display a screen including at least one battery cell determined as an abnormal battery cell on the display 145. For example, the apparatus 100 for controlling a vehicle may output, through a speaker, an audio signal indicating at least one battery cell determined as an abnormal battery cell. For example, the apparatus 100 for controlling a vehicle may transmit information about at least one battery cell determined as an abnormal battery cell to a user terminal (e.g., a smartphone) by using a communication circuit. However, the present disclosure is not limited thereto.

The apparatus 100 for controlling a vehicle may use battery cell information 122 to determine whether at least one battery cell diagnosed as an abnormal battery cell matches the battery cell information 122. The battery cell information 122 may include vehicle driving information and/or vehicle charging information.

For example, the battery cell information 122 may be obtained before identifying an input for diagnosing the battery 140. The battery cell information 122 may include information about at least one battery cell that is diagnosed as an abnormal battery cell while the vehicle is driven or charged. That is, the battery cell information 122 may include previous data.

For example, the apparatus 100 for controlling a vehicle may provide information about whether the abnormal battery cell determined in the no-load state matches the battery cell information 122 to a user by storing the information in the memory 120. However, the present disclosure is not limited thereto.

Referring to FIG. 1B, a block diagram related to an example of a system 101 for controlling a vehicle including the apparatus 100 for controlling a vehicle is illustrated.

For example, the system 101 for controlling a vehicle may include a vehicle control unit (VCU) 165, a motor controller unit (MCU) 160, a battery management unit (BMU) 155, and/or an audio, video, navigation (AVN) 150. The apparatus 100 for controlling a vehicle may control the VCU 165, the MCU 160, the BMU 155, and/or the AVN 150 to perform at least one of the operations of FIGS. 2 to 4 and FIGS. 6 to 10, but is not limited thereto.

For example, the system 101 for controlling a vehicle may perform at least one of the operations of FIGS. 2 to 4 and FIGS. 6 to 10 based on cooperative control between the VCU 165, the MCU 160, the BMU 155, and the AVN 150. In terms of cooperative control between the VCU 165, the MCU 160, the BMU 155, and the AVN 150, the system 101 for controlling a vehicle may be referred to as a cooperative control system.

For example, each of the VCU 165, the MCU 160, the BMU 155, and/or the AVN 150 may include at least one processor and memory. The description of at least one processor and memory may be referenced to the processor 110 and the memory 120 of FIG. 1A, respectively.

The system 101 for controlling a vehicle may receive an input for diagnosing a battery from an external electronic device 102. The external electronic device 102 may include a diagnostic device for diagnosing a vehicle or an external cloud server for identifying information about a vehicle, but is not limited thereto.

For example, the AVN 150 may obtain an input for diagnosing a battery by using a display (e.g., the display 145 of FIG. 1A).

For example, the system 101 for controlling a vehicle may initiate execution of a process for diagnosing a battery when a vehicle status condition (e.g., stopping or parking of a vehicle) is satisfied independently of receiving an input for diagnosing the battery 140.

The VCU 165 may temporarily release the coupling between the motor 130 and a drive shaft 175 for transmitting power generated by the motor 130 to the wheels in response to an input for diagnosing the battery 140.

For example, the battery 140 may further include a configuration (e.g., a sensor or a processor) for managing a battery. The battery 140 may be referred to as a battery management system.

For example, the VCU 165 may disconnect the connection between the motor 130 and the drive shaft 175 based on the execution of a DAS 170. For example, the VCU 165 may disconnect the connection between the motor 130 and the drive shaft 175 in a state where the vehicle is parked or stopped.

The MCU 160 may control the motor 130 according to profile information received from the BMU 155 in a no-load state where the coupling between the motor 130 and the drive shaft 175 is temporarily released.

For example, the MCU 160 may control the torque of the motor by controlling the inverter 135 according to the profile information. The BMU 155 may transmit (e.g., apply) a current corresponding to the magnitude of the torque to the inverter 135.

For example, when the MCU 160 increases the magnitude of the torque, the BMU 155 may increase the amount of the current transmitted to the inverter 135 corresponding to the magnitude of the torque. However, the present disclosure is not limited thereto.

For example, the MCU 160 may control the motor 130 by using the inverter 135. For example, the MCU 160 may drive the motor 130 by using the current that is output from the battery 140 by using the inverter 135.

For example, the MCU 160 may control the inverter 135 to change the torque direction of the motor 130. For example, the MCU 160 may control the inverter 135 to drive the motor 130 based on torque. For example, the MCU 160 may reduce the rotational power of the motor 130 by controlling the inverter to increase the counter torque.

For example, the MCU 160 may control the motor 130 such that the amount of the current to be output from the battery has a target value. The MCU 160 may control the current of the AC (alternating current) side of the inverter 135 such that the torque of the motor 130 has a target value. For example, the AC side of the inverter 135 and the motor 130 may be connected.

The BMU 155 may transmit profile information (e.g., the profile information 121 of FIG. 1A) for diagnosing an internal series resistance to the MCU 160.

For example, the BMU 155 may transmit profile information to the MCU 160 through the VCU 165. For example, the BMU 155 may transmit profile information including information about a target value of power that may be output from the battery 140 to the VCU 165. The VCU 165 may transmit the profile information to the MCU 160 together with information about a target value of torque that may be generated by the motor 130, but is not limited thereto.

For example, the BMU 155 may identify the current of the battery 140, the voltage of the battery 140, and/or the power of the battery 140 corresponding to the torque of the motor 130.

For example, the BMU 155 may obtain one or more parameters representing the internal series resistance for each of one or more battery cells included in the battery 140 by using current, voltage, and/or power. For example, the BMU 155 may determine at least one battery cell corresponding to at least one parameter exceeding a specified threshold among one or more parameters as an abnormal battery cell.

For example, the AVN 150 may display a screen including at least one battery cell determined to be an abnormal battery cell on a display.

As described above, the apparatus 100 for controlling a vehicle may identify the internal series resistance for each of one or more battery cells by disconnecting the connection between the motor 130 and the drive shaft. For example, because the larger the change in current, the easier it is to measure the internal series resistance, the internal series resistance may be obtained more accurately while the vehicle is driven at a high speed or the vehicle is rapidly charged. The apparatus 100 for controlling a vehicle may provide a diagnostic service to the user to obtain internal series resistance by disconnecting the connection between the motor 130 and the drive shaft in an environment where the vehicle is not driven at a high speed or there is no infrastructure for rapidly charging a vehicle (or battery).

FIG. 2 is a flowchart illustrating an example of an operation of a system for controlling a vehicle. Hereinafter, it is assumed that the apparatus 100 for controlling a vehicle of FIG. 1A or the system 101 for controlling a vehicle of FIG. 1B performs the process of FIG. 2. In addition, it may be understood in the description of FIG. 2 that operations described as being performed by an apparatus are controlled by the processor 110 of the apparatus 100 for controlling a vehicle. Each of the operations in FIG. 2 may be performed sequentially, but is not necessarily performed sequentially. For example, the order of each operation may be changed, and at least two operations may be performed in parallel.

In operation S210, the AVN of the system for controlling a vehicle may identify the execution of an abnormal diagnosis. For example, the AVN may identify the execution of abnormal diagnosis by receiving an input for diagnosing a battery through a display.

An apparatus for controlling a vehicle may identify the execution of an abnormal diagnosis. For example, the apparatus for controlling a vehicle may receive the input for diagnosing a battery while the vehicle is parked or stopped. The apparatus for controlling a vehicle may identify the execution of abnormal diagnosis based on the reception of the input for diagnosing a battery. The input for diagnosing a battery may include an input for performing abnormal diagnosis on one or more battery cells within the battery.

In operation S220, the BMU of the system for controlling a vehicle may request the VCU to execute the DAS. For example, the BMU may provide the VCU with profile information (e.g., the profile information 121 of FIG. 1) for diagnosing a battery.

The apparatus for controlling a vehicle may process the profile information obtained from the BMU by using the VCU.

In operation S230, the VCU of the system for controlling a vehicle may initiate execution of the DAS. The VCU of the system for controlling a vehicle may disconnect the connection between the motor and the drive shaft based on the execution of the DAS. Based on the disconnection between the motor and drive shaft, the system for controlling a vehicle may enter a no-load state. For example, in the no-load state, the power of the motor may not be transmitted to any wheels.

The apparatus for controlling a vehicle may enter a no-load state by disconnecting the connection between the motor and the drive shaft in response to an input for diagnosing a battery.

In operation S240, the VCU of the system for controlling a vehicle may request the MCU to drive the inverter. For example, the VCU may transmit the profile information obtained from the BMU to the MCU. For example, the MCU may use the profile information to initiate driving of the inverter.

The apparatus for controlling a vehicle may initiate driving of the inverter by using the profile information based on the disconnection between the motor and the drive shaft. The apparatus for controlling a vehicle may initiate driving of the inverter by using the MCU. However, the present disclosure is not limited thereto.

In operation S250, the MCU of the system for controlling a vehicle may drive the motor. The MCU may drive the motor by controlling the inverter according to the profile information. For example, the MCU may obtain torque by driving the motor based on the forward direction. The forward direction may indicate the direction of torque of the motor to drive the vehicle toward the front of the vehicle.

For example, the MCU may generate the counter torque by controlling the inverter to change the AC current. The MCU may reduce the magnitude of the torque by driving the motor based on the counter torque. The MCU may reduce the rotational power (or RPM) of the motor by driving the motor based on the counter torque.

For example, the MCU may drive the motor based on the torque by controlling the inverter using the discharging current output from the battery according to the profile information.

For example, the MCU may drive the motor by controlling the inverter using the current output from the battery according to the profile information.

For example, the MCU may change the direction in which the motor is driven by changing the direct current (DC) output from the battery to AC using the inverter according to the profile information.

The apparatus for controlling a vehicle may drive the motor by controlling the inverter according to the profile information. The apparatus for controlling a vehicle may control the motor based on the torque corresponding to the charging current or the discharging current.

In operation S260, the BMU of the system for controlling a vehicle may identify the internal series resistances of one or more battery cells included in the battery. For example, the BMU may identify the internal series resistance of each of one or more battery cells based on the voltage corresponding to the profile information associated with the battery. For example, the BMU may identify one or more parameters representing the internal series resistance of each of one or more battery cells. The BMU may obtain (or calculate) the standard deviation of one or more parameters.

The apparatus for controlling a vehicle may identify the internal series resistance of one or more battery cells. For example, the internal series resistance of the battery, which is identified while the apparatus for controlling a vehicle controls the inverter to drive the motor based on the torque, may be referred to as the discharging series resistance. For example, the internal series resistance of the battery, which is identified while the apparatus for controlling a vehicle drives the motor based on the counter torque, may be referred to as the charging series resistance.

In operation S270, the BMU of the system for controlling a vehicle may diagnose an abnormal battery cell. The BMU may use the standard deviation of one or more parameters to identify at least one parameter that exceeds a specified threshold (e.g., 3 sigma). The BMU may identify at least one parameter that exceeds a specified threshold from an average value of one or more parameters. The BMU may diagnose (or determine) at least one battery cell corresponding to at least one parameter as an abnormal battery cell. The BMU (and/or the BMS) may manage one or more batteries of the vehicle by means of, for example, alert notification, balancing actions, and/or reduced power output. For alert notification, the BMU may send an alert to the system operator, indicating which battery cell is abnormal and/or the nature of the abnormality. For balancing actions, the BMU may, for example, attempt to balance the battery pack by adjusting charging currents to individual cells to mitigate any imbalances. For reduced power output, the BMU may, for example, limit the battery's power output to protect against potential damage from the abnormal battery cell.

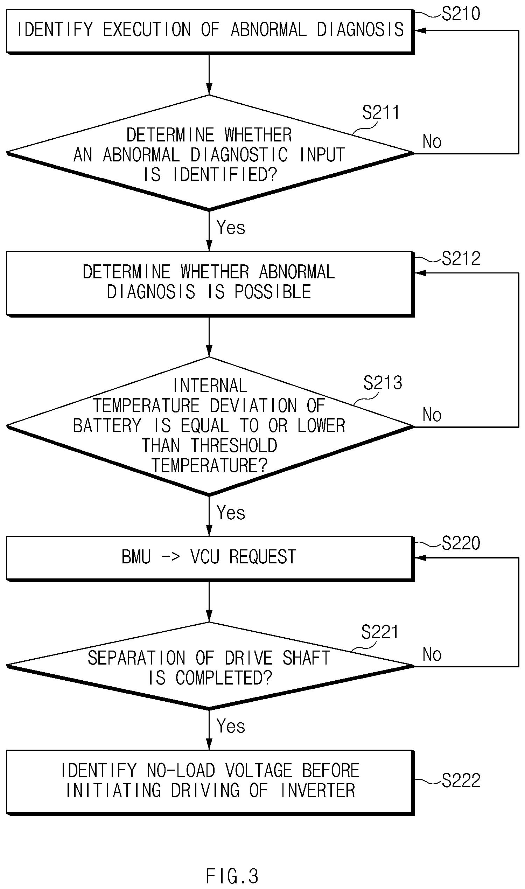

FIG. 3 is a flowchart illustrating an example of an operation of initiating abnormal diagnosis of a battery by a system for controlling a vehicle. Hereinafter, it is assumed that the apparatus 100 for controlling a vehicle of FIG. 1A or the system 101 for controlling a vehicle of FIG. 1B performs the process of FIG. 3. In addition, it may be understood in the description of FIG. 3 that operations described as being performed by an apparatus are controlled by the processor 110 of the apparatus 100 for controlling a vehicle. Each of the operations in FIG. 3 may be performed sequentially, but is not necessarily performed sequentially. For example, the order of each operation may be changed, and at least two operations may be performed in parallel. At least one of the operations in FIG. 3 may be related to at least one of the operations in FIG. 2.

In operation S210, the AVN of the system for controlling a vehicle may identify the execution of an abnormal diagnosis. For example, the AVN may identify the execution of abnormal diagnosis by receiving an input for diagnosing a battery through a display.

In operation S211, the AVN of the system for controlling a vehicle may determine whether an abnormal diagnostic input is identified. For example, the abnormal diagnostic input may be included in the input for diagnosing a battery. For example, the AVN may receive the abnormal diagnostic input by displaying a user interface (UI) for diagnosing a battery on the display. The AVN may identify the abnormal diagnostic input received from an external electronic device. However, the present disclosure is not limited thereto.

For example, when the abnormal diagnostic input is not identified (operation S211 - No), the AVN may perform operation S210. When the abnormal diagnostic input is identified (operation S211 - Yes), the AVN may perform operation S212.

The apparatus for controlling a vehicle may determine whether the input for diagnosing a battery is received. When the apparatus for controlling a vehicle does not receive an input for diagnosing the battery, the apparatus for controlling a vehicle may perform operation S210. For example, when the apparatus for controlling a vehicle receives the input for diagnosing a battery, the apparatus for controlling a vehicle may identify the internal temperature of the battery.

In operation S212, the BMU of the system for controlling a vehicle may determine whether an abnormal diagnosis is possible.

In operation S213, the BMU of the system for controlling a vehicle may determine whether the internal temperature deviation of the battery is equal to or lower than a threshold temperature.

For example, the BMU of the system for controlling a vehicle may identify the internal temperature deviation to improve the accuracy of battery diagnosis.

For example, the BMU of the system for controlling a vehicle may perform operation S212 when the internal temperature deviation of the battery is equal to or lower than the threshold temperature (operation S213 - No).

For example, the BMU of the system for controlling a vehicle may perform operation S220 if the internal temperature deviation of the battery exceeds the threshold temperature (operation S213-Yes).

In operation S220, the BMU of the system for controlling a vehicle may request the VCU to execute the DAS. For example, the BMU may provide the VCU with the profile information for diagnosing the battery (e.g., the profile information 121 of FIG. 1).

In operation S221, the BMU of the system for controlling a vehicle may determine whether separation of the drive shaft is completed. The BMU may determine whether the connection between the drive shaft and the motor is disconnected. For example, the BMU of the system for controlling a vehicle may determine whether the separation of the drive shaft is complete by receiving a signal from the VCU indicating that the connection between the drive shaft and the motor is disconnected.

For example, when the separation of the drive shaft is not completed (operation S221 - No), the BMU may perform operation S220. For example, the BMU may request a signal from the VCU indicating whether the connection between the drive shaft and the motor is disconnected. However, the present disclosure is not limited thereto.

After the separation of the drive shaft is completed (operation S221 - Yes), in operation S222, the BMU may identify the no-load voltage of the battery before initiating driving of the inverter. For example, the BMU may identify the no-load voltage of each of one or more battery cells included in the battery.

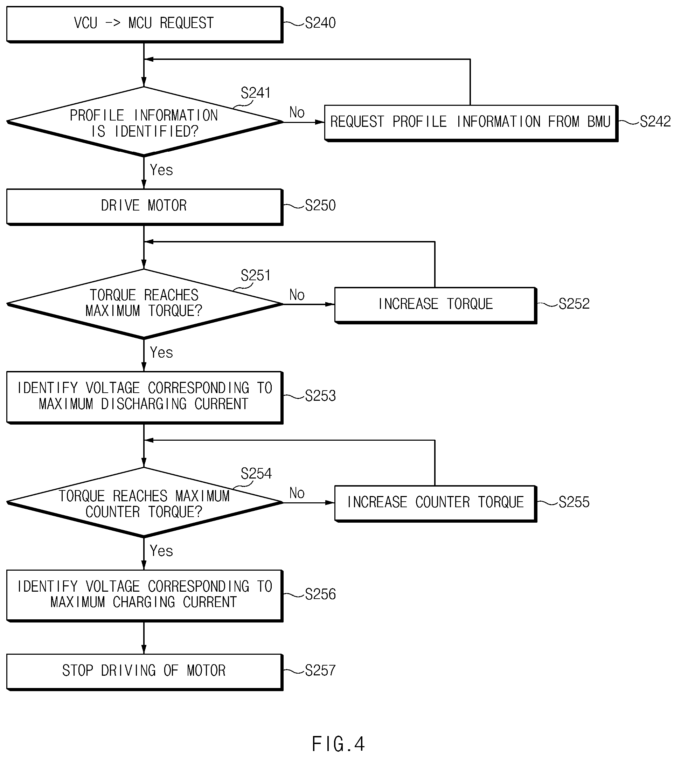

FIG. 4 is a flowchart illustrating an example of an operation of controlling a motor to identify the internal series resistance of a battery by a system for controlling a vehicle. Hereinafter, it is assumed that the apparatus 100 for controlling a vehicle of FIG. 1A or the system 101 for controlling a vehicle of FIG. 1B performs the process of FIG. 4. In addition, it may be understood in the description of FIG. 4 that operations described as being performed by an apparatus are controlled by the processor 110 of the apparatus 100 for controlling a vehicle. Each of the operations in FIG. 4 may be performed sequentially, but is not necessarily performed sequentially. For example, the order of each operation may be changed, and at least two operations may be performed in parallel. At least one of the operations in FIG. 4 may be related to at least one of the operations in FIG. 2.

In operation S240, the VCU of the system for controlling a vehicle may request the MCU to drive the inverter.

In operation S241, the VCU may determine whether the profile information is identified. For example, when the profile information is not identified (operation S241 - No), in operation S242, the VCU may request the profile information from the BMU.

For example, when the profile information is identified (operation S241 - Yes), the system for controlling a vehicle may perform operation S250.

In operation S250, the MCU of the system for controlling a vehicle may drive the motor. The MCU may drive the motor by controlling the inverter according to the profile information.

For example, the MCU may obtain the torque by driving the motor according to the profile information. The MCU may obtain the torque to maximize the amount of current to drive the motor or the amount of change in current.

For example, the current output from the battery while driving the motor based on the torque may include the discharging current.

In operation S251, the MCU may determine whether the torque of the motor reaches the maximum torque. The MCU may determine whether the value corresponding to the motor torque is the target value. For example, the MCU may use the profile information to determine whether the value corresponding to the motor torque is the target value. For example, the current corresponding to the maximum torque may have a maximum value.

For example, the maximum torque may represent the case where the torque of the motor has a maximum value.

For example, when the torque of the motor does not reach the maximum torque (operation S251 - No), in operation S252, the MCU may control the inverter to increase the torque of the motor. To increase the motor torque, the BMU may increase the amount of current output from the battery (e.g., discharging current).

When the torque of the motor reaches the maximum torque (operation S251 - Yes), the BMU of the system for controlling a vehicle may identify the first voltage corresponding to the maximum discharging current in operation S253.

For example, when the torque of the motor reaches the maximum torque, the value of the discharging current output from the battery may have a maximum value. The discharging current corresponding to the maximum value may be referred to as the maximum discharging current.

For example, after obtaining the maximum discharging current and the first voltage, the MCU may drive the motor based on the counter torque.

In operation S254, the MCU may determine whether the counter torque of the motor reaches the maximum counter torque while driving the motor based on the counter torque.

When the counter torque of the motor does not reach the maximum counter torque (operation S254 - No), the MCU may increase the counter torque of the motor. The MCU may use the current obtained based on the rotational force of the motor to increase the counter torque of the motor. However, the present disclosure is not limited thereto.

When the counter torque of the motor reaches the maximum counter torque (operation S254 - Yes), the BMU of the system for controlling a vehicle may identify the second voltage corresponding to the maximum charging current in operation S256. The maximum charging current may represent the current having a maximum value when the current value has a maximum value while the motor is driven based on the counter torque.

For example, after identifying the second voltage and maximum charging current, the MCU may stop driving the motor.

In operation S257, the MCU of the system for controlling a vehicle may stop driving the motor. For example, the MCU may stop driving the motor by stopping control of the inverter. For example, the BMU of the system for controlling a vehicle may stop outputting current from the battery after identifying the first voltage and the maximum discharge current. Because the current output from the battery is cut off, the motor may stop running.

FIG. 5 is a diagram illustrating an example of profile information for identifying the internal series resistance of a battery by a system for controlling a vehicle. Referring to FIG. 5, an example of the graph 500 representing profile information (e.g., the profile information 121 of FIG. 1A) is illustrated.

The graph 500 may include a graph 501 representing the magnitude of torque over time, a graph 502 representing the magnitude of voltage, and/or a graph 503 representing the magnitude of current output from the battery. For example, the graph 500 may include information (e.g., current or voltage) corresponding to each of one or more battery cells. For example, the graph 503 may have the form of a square wave.

Referring to the graph 501, it may be understood that the magnitude of torque increases in a first time interval 510. To increase the magnitude of torque, the apparatus for controlling a vehicle may increase the amount of current output from the battery. The apparatus for controlling a vehicle may identify the maximum discharging current at a time point 505. The time point 505 may represent a time point when the value of current output from the battery fluctuates relatively significantly. The apparatus for controlling a vehicle may identify a voltage corresponding to the maximum discharging current identified at the time point 505.

For example, the first time interval 510 may be referred to as a discharge interval. In the first time interval, the apparatus for controlling a vehicle may control the inverter to drive the motor based on the torque. The current identified while driving the motor using the inverter based on the torque may be referred to as a discharging current.

Referring to the graph 501, in a second time interval 520, the apparatus for controlling a vehicle may drive the motor based on the counter torque. The second time interval 520 may be referred to as a charging section. The current identified during the second time interval may be referred to as a charging current.

The apparatus for controlling a vehicle may identify a maximum discharging current, a voltage corresponding to the maximum discharging current, a maximum charging current, and/or a voltage corresponding to the maximum charging current by controlling the motor and the battery to match the graph 500. The apparatus for controlling a vehicle may identify, for each of one or more battery cells, the maximum discharging current, the voltage corresponding to the maximum discharging current, the maximum charging current, and/or the voltage corresponding to the maximum charging current. However, the present disclosure is not limited thereto.

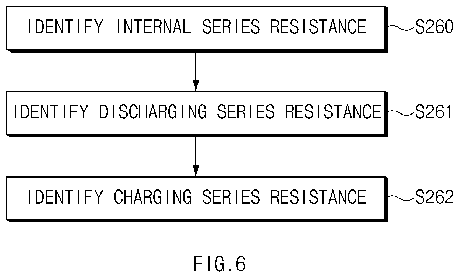

FIG. 6 is a flowchart illustrating an example of an operation of identifying an internal series resistance by a system for controlling a vehicle. Hereinafter, it is assumed that the apparatus 100 for controlling a vehicle of FIG. 1A or the system 101 for controlling a vehicle of FIG. 1B performs the process of FIG. 6. In addition, it may be understood in the description of FIG. 6 that operations described as being performed by an apparatus are controlled by the processor 110 of the apparatus 100 for controlling a vehicle. Each of the operations in FIG. 6 may be performed sequentially, but is not necessarily performed sequentially. For example, the order of each operation may be changed, and at least two operations may be performed in parallel. At least one of the operations in FIG. 6 may be related to at least one of the operations in FIG. 2.

In operation S260, the BMU of the system for controlling a vehicle may identify internal series resistances of one or more battery cells included in the battery.

In operation S261, the BMU of the system for controlling a vehicle may identify a discharging series resistance. The discharging series resistance may be identified using the maximum discharge current and voltage obtained in the first time interval (e.g., the first time interval 510 of FIG. 5).

For example, the BMU of the system for controlling a vehicle may obtain one or more parameters representing the discharging series resistance of each of one or more battery cells by using the no-load voltage, maximum discharging current, and voltage.

For example, the BMU of the system for controlling a vehicle may obtain one or more parameters representing the internal series resistance (or discharging series resistance) of each of one or more battery cells by using Equation 1.

【Equation 1】

$$R_{\mathrm{dchg}_{cell1\sim n}} = \frac{V_{\mathrm{noload}_{cell1\sim n}} - V_{\mathrm{dchg}_{cell1\sim n}}}{I_{dchg}}$$

Referring to Equation 1, for example, $R_{\mathrm{dchg\_cell1\sim n}}$ may mean one or more parameters representing the internal series resistance (or discharging series resistance) of each of one or more battery cells. For example, $V_{\mathrm{noload\_cell1\sim n}}$ may represent the no-load voltage of each of one or more battery cells. $V_{\mathrm{dchg\_cell1\sim n}}$ may represent the voltage of each of one or more battery cells corresponding to the maximum discharging current (e.g., $I_{dchg}$ in Equation 1). cell1~n may represent the identification numbers of each of one or more battery cells.

The apparatus for controlling a vehicle may identify the discharging series resistance of each of one or more battery cells by using Equation 1.

In operation S262, the BMU of the system for controlling a vehicle may identify the charging series resistance. The charging series resistance may be identified using the maximum charging current and voltage obtained in the second time interval (e.g., the second time interval 520 of FIG. 5).

For example, the BMU of the system for controlling a vehicle may obtain one or more parameters representing the charging series resistance of each of one or more battery cells by using the no-load voltage, maximum charging current, and voltage.

For example, the BMU of the system for controlling a vehicle may obtain one or more parameters representing the internal series resistance (or charging series resistance) of each of one or more battery cells by using Equation 2.

【Equation 2】

$$R_{\mathrm{chg}_{cell1\sim n}} = \frac{V_{\mathrm{chg}_{cell1\sim n}} - V_{\mathrm{dchg}_{cell1\sim n}}}{I_{chg} - I_{dchg}}$$

Referring to Equation 2, for example, $R_{\mathrm{chg\_cell1\sim n}}$ may mean one or more parameters representing the charging series resistance of each of one or more battery cells. For example, $V_{\mathrm{chg\_cell1\sim n}}$ may represent the voltage of each of one or more battery cells corresponding to the maximum charging current (e.g., $I_{chg}$ in Equation 2).

The apparatus for controlling a vehicle may identify the charging series resistance of each of one or more battery cells by using Equation 2.

The BMU of the system for controlling a vehicle may determine an abnormal battery cell among one or more battery cells based on identifying the discharging series resistance and charging series resistance.

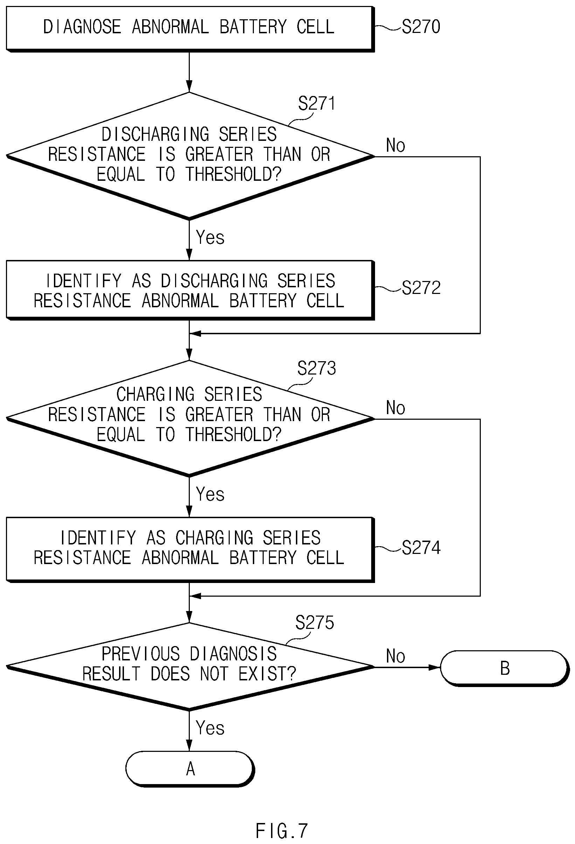

FIG. 7 is a flowchart illustrating an example of an operation of diagnosing an abnormal battery cell by a system for controlling a vehicle. Hereinafter, it is assumed that the apparatus 100 for controlling a vehicle of FIG. 1A or the system 101 for controlling a vehicle of FIG. 1B performs the process of FIG. 7. In addition, it may be understood in the description of FIG. 7 that the operations described as being performed by an apparatus are controlled by the processor 110 of the apparatus 100 for controlling a vehicle. Each of the operations in FIG. 7 may be performed sequentially, but is not necessarily performed sequentially. For example, the order of each operation may be changed, and at least two operations may be performed in parallel. At least one of the operations in FIG. 7 may be related to at least one of the operations in FIG. 2.

In operation S270, the BMU of the system for controlling a vehicle may diagnose an abnormal battery cell.

In operation S271, the BMU of the system for controlling a vehicle may determine whether the discharging series resistance is greater than or equal to a threshold.

For example, the BMU may obtain standard deviations for one or more parameters corresponding to each of one or more battery cells.

For example, the BMU may use the standard deviation to identify at least one parameter included within a specified region. The specified region may represent a region that includes values greater than or equal to a specified threshold rather than the average value in a graph showing standard deviations.

For example, when the discharging series resistance for at least one battery cell among the one or more battery cells is less than a specified threshold (operation S271 - No), the BMU may perform operation S273. For example, the BMU may determine whether the charging series resistance for at least one battery cell is abnormal.

When the discharging series resistance for at least one battery cell among the one or more battery cells is greater than or equal to the specified threshold (operation S271 - Yes), in operation S272, the BMU may identify the at least one battery cell having the discharging series resistance greater than or equal to the specified threshold as a discharging series resistance abnormal battery cell.

In operation S273, the BMU of the system for controlling a vehicle may determine whether the charging series resistance is greater than or equal to the threshold value. For example, when the charging series resistance for at least one battery cell among one or more battery cells is below the specified threshold (operation S273 - No), the BMU may perform operation S275.

When the charging series resistance of at least one battery cell among one or more battery cells is greater than or equal to the specified threshold (operation S273 - Yes), in operation S274, the BMU may identify at least one battery cell having the charging series resistance greater than or equal to the specified threshold as a charging series resistance abnormal battery cell.

The BMU of the system for controlling a vehicle may determine whether there is no previous diagnosis result in operation S275. The previous diagnosis result may be referenced to the battery cell information 122 of FIG. 1A.

When there is no previous diagnosis result (operation S275 - Yes), the system for controlling a vehicle may enter 'A' of FIG. 7. When there is a previous diagnosis result (operation S275 - NO), the system for controlling a vehicle may enter 'B' of FIG. 7.

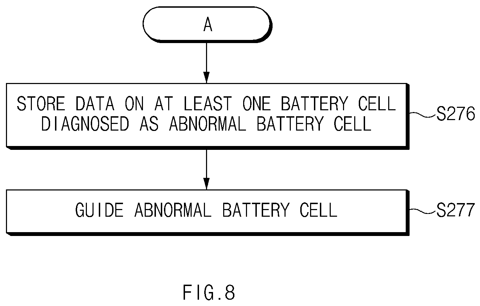

FIG. 8 is a flowchart illustrating an example of an operation of guiding an abnormal battery cell by a system for controlling a vehicle. Hereinafter, it is assumed that the apparatus 100 for controlling a vehicle of FIG. 1A or the system 101 for controlling a vehicle of FIG. 1B performs the process of FIG. 8. In addition, it may be understood in the description of FIG. 8 that operations described as being performed by an apparatus are controlled by the processor 110 of the apparatus 100 for controlling a vehicle. Each of the operations in FIG. 8 may be performed sequentially, but is not necessarily performed sequentially. For example, the order of each operation may be changed, and at least two operations may be performed in parallel. At least one of the operations in FIG. 8 may be related to at least one of the operations in FIG. 7.

In operation S276, the system for controlling a vehicle, which enters 'A' of FIG. 7, may store data on at least one battery cell diagnosed as an abnormal battery cell. At least one battery cell diagnosed as an abnormal battery cell may include a charging series resistance abnormal battery cell and/or a discharging series resistance abnormal battery cell.

For example, data about at least one battery cell diagnosed as an abnormal battery cell may include identification information of at least one battery cell diagnosed as an abnormal battery cell.

In operation S277, the system for controlling a vehicle may guide the user to an abnormal battery cell (e.g., the vehicle may notify the user of the abnormal battery cell). The AVN of the system for controlling a vehicle may display a screen including information indicating an abnormal battery cell on the display.

For example, the screen may include information related to an abnormal state of the battery.

The AVN of the system for controlling a vehicle may transmit information indicating an abnormal battery cell to an external electronic device. However, the present disclosure is not limited thereto.

For example, information indicating an abnormal battery cell may be used to manage the vehicle. An operation of the vehicle may be performed based on the information about the abnormal battery. The operation of the vehicle performed (e.g., controlled) based on the abnormal battery may include, for example, adjusting (e.g., increasing or decreasing) the speed of the vehicle, outputting a warning message to the user, transmitting a warning message to an external device, transmitting the information to a vehicle service facility, disabling the abnormal battery, adjusting a range of the vehicle, etc. The operation of the vehicle may be performed by, for example, the VCU, the MCU, and/or the BMU.

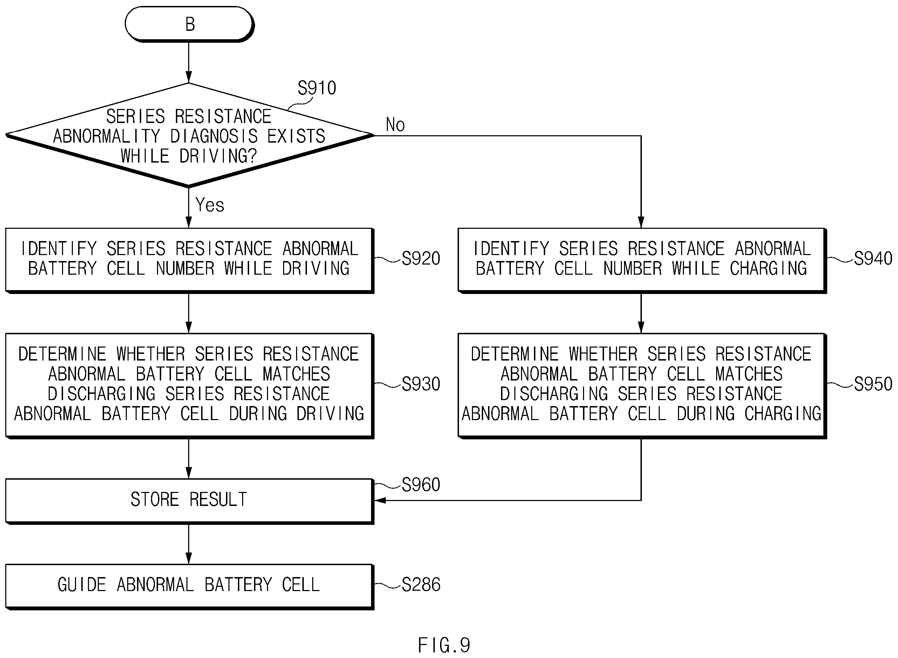

FIG. 9 is a flowchart illustrating an example of an operation of identifying an abnormal battery cell using previous diagnostic data by a system for controlling a vehicle. Hereinafter, it is assumed that the apparatus 100 for controlling a vehicle of FIG. 1A or the system 101 for controlling a vehicle of FIG. 1B performs the process of FIG. 9. In addition, it may be understood in the description of FIG. 9 that operations described as being performed by an apparatus are controlled by the processor 110 of the apparatus 100 for controlling a vehicle. Each of the operations in FIG. 9 may be performed sequentially, but is not necessarily performed sequentially. For example, the order of each operation may be changed, and at least two operations may be performed in parallel. At least one of the operations in FIG. 9 may be related to at least one of the operations in FIG. 7.

In operation S910, the BMU of the system for controlling a vehicle that enters 'B' of FIG. 7 may determine whether there is a series resistance abnormality diagnosis while driving.

For example, the BMU may determine whether at least one battery cell diagnosed as an abnormal battery cell in operation S270 matches the abnormal battery cell information.

When there is a series resistance abnormality diagnosis (operation S910 - Yes), in operation S920, the BMU of the system for controlling a vehicle may use the abnormal battery cell (e.g., the battery cell information 122 of FIG. 1A) to identify the abnormal battery cell identified while the vehicle is driven.

In operation S930, the BMU of the system for controlling a vehicle may determine whether a series resistance abnormal battery cell and a discharging series resistance abnormal battery cell match during driving.

In operation S960, the BMU of the system for controlling a vehicle may store information indicating whether a series resistance abnormal battery cell and a discharging series resistance abnormal battery cell match during driving.

In operation S286, the AVN of the system for controlling a vehicle may guide the abnormal battery cell. For example, the AVN of the system for controlling a vehicle may guide the user together with information indicating whether there is a match between a series resistance abnormal battery cell and a discharging series resistance abnormal battery cell while driving.

When there is no series resistance abnormality diagnosis (operation S910 - No), in operation S940, the BMU of the system for controlling a vehicle may identify the identified series resistance abnormal cell while charging the vehicle. The BMU of the system for controlling a vehicle may identify an abnormal battery cell while charging the vehicle by using the abnormal battery cell (e.g., the battery cell information 122 of FIG. 1A).

In operation S950, the BMU of the system for controlling a vehicle may determine whether a series resistance abnormal battery cell and a charging series resistance abnormal battery cell match during charging.

In operation S960, the BMU of the system for controlling a vehicle may store information indicating whether a series resistance abnormal battery cell and a charging series resistance abnormal battery cell match during charging. For example, the AVN of the system for controlling a vehicle may perform operation S286.

As described above, the system for controlling a vehicle (or the apparatus for controlling a vehicle) may reconfirm abnormal cell information of a battery obtained while driving or charging the vehicle by performing at least one of the operations of FIG. 9. The system for controlling a vehicle may provide the user with information on abnormal battery cells identified during driving and information on abnormal battery cells identified during charging. The information provided to the user may be used to maintain (or repair) the vehicle (or battery).

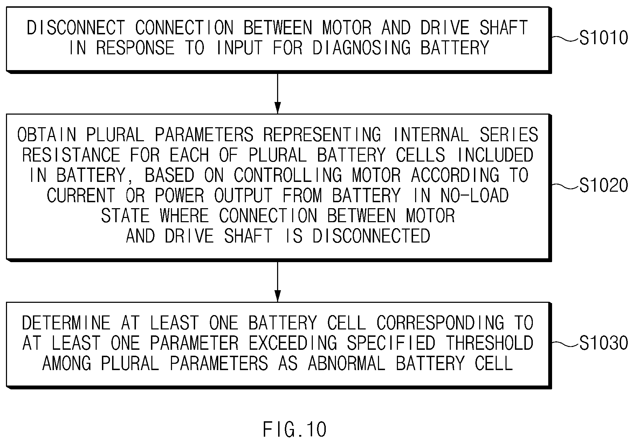

FIG. 10 is a flowchart illustrating a method of controlling a vehicle. Hereinafter, it is assumed that the apparatus 100 for controlling a vehicle of FIG. 1 performs the process of FIG. 10. In addition, it may be understood in the description of FIG. 10 that operations described as being performed by an apparatus are controlled by the processor 110 of the apparatus 100 for controlling a vehicle. Each of the operations in FIG. 10 may be performed sequentially, but is not necessarily performed sequentially. For example, the order of each operation may be changed, and at least two operations may be performed in parallel.

A method of controlling a vehicle may include an operation S1010 of disconnecting the connection between the motor and the drive shaft in response to an input for diagnosing a battery. For example, the method of controlling a vehicle may include an operation of receiving the input for diagnosing a battery while the vehicle is parked or stopped. The method of controlling a vehicle may include an operation of receiving the input for diagnosing a battery by using a UI for diagnosing a battery on a display.

The method of controlling a vehicle may include operation S1020 of obtaining one or more parameters representing internal series resistance for each of one or more battery cells included in a battery, based on controlling the motor according to the current or power related to the battery in a no-load state where the connection between the motor and the drive shaft is disconnected. The current or power associated with the battery may be obtained through profile information associated with the battery.

For example, the method of controlling a vehicle may include an operation of driving the motor by controlling the inverter using the current output from the battery.

For example, the method of controlling a vehicle may include an operation of identifying the current output from the battery as a discharging current while driving the motor based on the torque.

For example, the method of controlling a vehicle may include an operation of identifying the internal series resistance corresponding to the discharging current as a discharging series resistance. For example, the method of controlling a vehicle may include an operation of identifying the discharging series resistance by using the maximum discharging current and the voltage corresponding to the maximum discharging current.

For example, the maximum discharging current may be identified within the first time interval (e.g., the first time interval 510 of FIG. 5).

For example, the method of controlling a vehicle may include an operation of identifying the current obtained based on the rotational power of the motor as a charging current while driving the motor based on the counter torque generated by controlling the inverter.

For example, the method of controlling a vehicle may include an operation of identifying the internal series resistance corresponding to the charging current as a charging series resistance. For example, the method of controlling a vehicle may include an operation of identifying the charging series resistance by using the maximum charging current and the voltage corresponding to the maximum charging current.

For example, the maximum charging current may be identified within the second time interval (e.g., the second time interval 520 of FIG. 5).

The method of controlling a vehicle may include an operation S1030 of determining at least one battery cell corresponding to at least one parameter exceeding a specified threshold among one or more parameters as an abnormal battery cell.

The method of controlling a vehicle may include an operation of identifying at least one battery cell having an error value for the discharging series resistance by using the standard deviation of the first parameters for the discharging series resistance.

For example, the method of controlling a vehicle may include an operation of determining at least one battery cell corresponding to at least one parameter exceeding the specified threshold using the standard deviation of the first parameters as a discharging series resistance abnormal battery cell.

For example, the method of controlling a vehicle may include an operation of guiding a user to at least one battery cell that is determined as a discharging series resistance abnormal battery cell. For example, the method of controlling a vehicle may display the screen including at least one battery cell on the display.

For example, the method of controlling a vehicle may include an operation of determining whether at least one battery cell matches a series resistance abnormal battery cell included in the abnormal battery cell information (e.g., the battery cell information 122 of FIG. 1A) during driving.

For example, the method of controlling a vehicle may include an operation of displaying, on a display, information indicating whether at least one battery cell matches a series resistance abnormal battery cell during driving.

The method of controlling a vehicle may include an operation of identifying at least one battery cell having an error value for the charging series resistance by using the standard deviation of the second parameters for the charging series resistance.

For example, the method of controlling a vehicle may include an operation of determining at least one battery cell corresponding to at least one parameter exceeding the specified threshold by using the standard deviation of the second parameters as a charging series resistance abnormal battery cell.

For example, the method of controlling a vehicle may include an operation of guiding a user to at least one battery cell determined as a charging series resistance abnormal battery cell. For example, the method of controlling a vehicle may display the screen including at least one battery cell on the display.

For example, the method of controlling a vehicle may include an operation of determining whether at least one battery cell matches a series resistance abnormal battery cell included in the abnormal battery cell information (e.g., the battery cell information 122 of FIG. 1A) during charging.

For example, the method of controlling a vehicle may include an operation of displaying, on the display, information indicating whether at least one battery cell matches a series resistance abnormal battery cell during charging.

As described above, the apparatus for controlling a vehicle, which performs the method of controlling a vehicle, may identify the internal series resistance of the battery by disconnecting the connection between the motor and the drive shaft while the vehicle is stopped from driving (e.g., ignition off). The apparatus for controlling a vehicle may provide a user with a service of diagnosing an abnormal battery cell using the internal series resistance of the battery, independently of whether the vehicle is driven or whether the vehicle is rapidly charged.

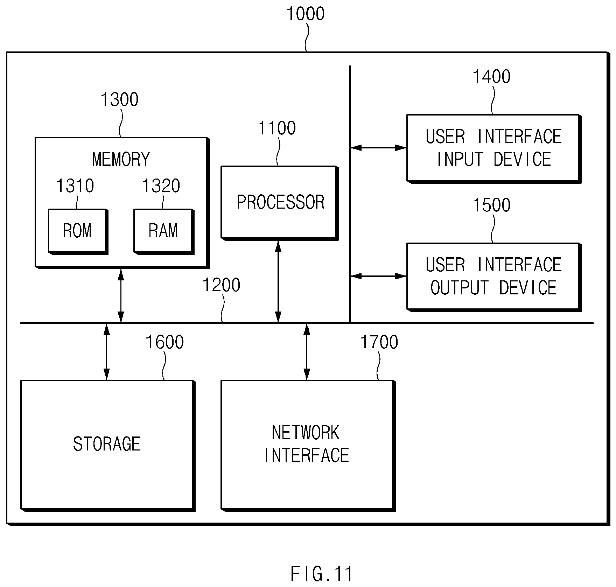

FIG. 11 is a block diagram illustrating a computing system related to the apparatus 100 for controlling a vehicle or a method of controlling a vehicle.

Referring to FIG. 11, The computing system 1000 may include at least one processor 1100, a memory 1300, a user interface input device 1400, a user interface output device 1500, storage 1600, and a network interface 1700 connected through a system bus 1200.

The processor 1100 may be a central processing device (CPU) or a semiconductor device that processes instructions stored in the memory 1300 and/or the storage 1600. The memory 1300 and the storage 1600 may include various types of volatile or non-volatile storage media. For example, the memory 1300 may include a ROM1310 and a RAM 1320.

Thus, the operations of the method or the algorithm described in connection with the example embodiments disclosed herein may be embodied directly in hardware or a software module executed by the processor 1100, or in a combination thereof. The software module may reside on a storage medium (that is, the memory 1300 and/or the storage 1600) such as a RAM, a flash memory, a ROM, an erasable programmable ROM (EPROM), an electrically erasable programmable ROM (EEPROM), a register, a hard disk, a solid-state drive (SSD), a removable disk, an optical disc, and a compact disc ROM (CD-ROM).

The exemplary storage medium may be coupled to the processor 1100, and the processor 1100 may read information out of the storage medium and may record information in the storage medium. Alternatively, the storage medium may be integrated with the processor 1100. The processor 1100 and the storage medium may reside in an application specific integrated circuit (ASIC). The ASIC may reside within a user terminal. In another case, the processor 1100 and the storage medium may reside in the user terminal as separate components.

According to one aspect of the present disclosure, an apparatus for controlling a vehicle includes a processor, a memory, a battery, and a motor, wherein the processor disconnects a connection between the motor and a drive shaft in response to an input for diagnosing the battery, obtains one or more parameter that represents an internal series resistance for each of one or more battery cells included in the battery, based on controlling the motor according to status information related to the battery in a no-load state where the connection between the motor and the drive shaft is disconnected, and determines at least one battery cell corresponding to at least one parameter exceeding a specified threshold among the one or more parameters as an abnormal battery cell.

For example, the processor may identify a discharging current output from the battery while controlling the motor based on a torque according to the status information, obtain a first voltage corresponding to the discharging current, and obtain first parameters representing the internal series resistance for the discharging current among the one or more parameters by using at least one of the discharging current, or the first voltage, or any combination thereof.

For example, the processor may transmit a charging current obtained while controlling the motor based on a counter torque according to the status information to the battery after controlling the motor based on the torque, obtain a second voltage corresponding to the charging current, and obtain second parameters representing the internal series resistance for the charging current among the one or more parameters by using at least one of the discharging current, the charging current, the first voltage, or the second voltage, or any combination thereof.

For example, the processor may identify the at least one parameter exceeding the specified threshold by using at least one of a standard deviation of the first parameters, or a standard deviation of the second parameters, or any combination thereof.

For example, the processor may obtain the first voltage corresponding to a target value of the discharging current by increasing an amount of the discharging current.

For example, the processor may obtain the second voltage corresponding to a target value of the charging current by increasing an amount of the charging current.

For example, the processor may obtain a no-load voltage of the battery before controlling the motor in the no-load state, and obtain the first parameters by using the discharging current, the first voltage, and the no-load voltage.

For example, the processor may obtain the one or more parameters corresponding to a current target value by increasing a torque of the motor based on controlling the motor by using the status information for diagnosing the internal series resistance.

For example, the apparatus may further include a display, wherein the processor may display information related to an abnormal state of the battery on the display when the at least one battery cell is determined as the abnormal battery cell.

For example, the processor may determine whether the at least one battery cell diagnosed as the abnormal battery cell matches battery cell information by using the battery cell information obtained before identifying the input for diagnosing the battery.

According to another aspect of the present disclosure, a method of controlling a vehicle includes disconnecting a connection between a motor and a drive shaft in response to an input for diagnosing a battery, obtaining one or more parameters that represent an internal series resistance for each of one or more battery cells included in the battery, based on controlling the motor according to status information related to the battery in a no-load state where the connection between the motor and the drive shaft is disconnected, and determining at least one battery cell corresponding to at least one parameter exceeding a specified threshold among the one or more parameters as an abnormal battery cell.

For example, the obtaining of the one or more parameters may include identifying a discharging current output from the battery while controlling the motor based on a torque, obtaining a first voltage corresponding to the discharging current, and obtaining first parameters representing the internal series resistance for the discharging current among the one or more parameters by using the discharging current and the first voltage.

For example, the obtaining of the one or more parameters may include transmitting a charging current obtained while controlling the motor based on a counter torque to the battery after controlling the motor based on the torque, obtaining a second voltage corresponding to the charging current, and obtaining second parameters representing the internal series resistance for the charging current among the one or more parameters by using at least one of the discharging current, the charging current, the first voltage, or the second voltage, or any combination thereof.

For example, the determining of the at least one battery as the abnormal battery may include identifying the at least one parameter exceeding the specified threshold by using at least one of a standard deviation of the first parameters, or a standard deviation of the second parameters, or any combination thereof.

For example, the obtaining of the first voltage may include obtaining the first voltage corresponding to a target value of the discharging current by increasing an amount of the discharging current.

For example, the obtaining of the second voltage may include obtaining the second voltage corresponding to a target value of the charging current by increasing an amount of the discharging current.

For example, the obtaining of the first parameters may include obtaining a no-load voltage of the battery before controlling the motor in the no-load state, and obtaining the first parameters by using the discharging current, the first voltage, and the no-load voltage.

For example, the obtaining of the one or more parameters may include obtaining the one or more parameters corresponding to a current target value by increasing a torque of the motor based on controlling the motor by using the status information for diagnosing the internal series resistance.

For example, the method may further include displaying information related to an abnormal state of the battery on a display when the at least one battery cell is determined as the abnormal battery cell.

According to still another aspect of the present disclosure, a system for controlling a vehicle includes a vehicle control unit (VCU), a motor controller unit (MCU), and a battery management unit (BMU), wherein the VCU temporarily disengages a coupling between a motor and a drive shaft for transmitting power generated by the motor to a wheel in response to an input for diagnosing a battery, the MCU obtains a torque by controlling the motor according to status information received from the BMU in a no-load state where the coupling between the motor and the drive shaft is temporarily disengaged, and the BMU transmits the status information for diagnosing an internal series resistance to the VCU, identifies a current of the battery and a voltage of the battery corresponding to the torque, obtains one or more parameters representing an internal series resistance for each of one or more battery cells included in the battery by using the current and the voltage, and diagnoses at least one battery cell corresponding to at least one parameter exceeding a specified threshold among the one or more parameters as an abnormal battery cell.

The present technology may diagnose a battery while a vehicle moves or is parked.

The present technology may diagnose a battery by disconnecting the connection between a motor and a drive shaft.

In addition, the present technology may reconfirm abnormal battery cell information obtained while a vehicle is charged or driven.

In addition, various effects that are directly or indirectly understood through the present disclosure may be provided.

Although one or more example embodiments of the present disclosure have been described for illustrative purposes, those skilled in the art will appreciate that various modifications, additions and substitutions are possible, without departing from the scope and spirit of the disclosure.

Therefore, the example embodiments disclosed in the present disclosure are provided for the sake of descriptions, not limiting the technical concepts of the present disclosure, and it should be understood that such example embodiments are not intended to limit the scope of the technical concepts of the present disclosure. The protection scope of the present disclosure should be understood by the claims below, and all the technical concepts within the equivalent scopes should be interpreted to be within the scope of the right of the present disclosure.

**Claims**

1. An apparatus for controlling a vehicle, the apparatus comprising:

   a processor;
   memory;
   a battery comprising one or more battery cells; and
   a motor,
   wherein the processor is configured to:

   disconnect, based on receiving a request for diagnosing the battery, the motor from a drive shaft;
   obtain, based on controlling the motor according to status information of the battery in a no-load state where the motor is disconnected from the drive shaft, one or more parameters that indicate an internal series resistance of each of the one or more battery cells;
   identify an abnormal battery cell, of the one or more battery cells, corresponding to a parameter, of the one or more parameters, that exceeds a threshold value; and
   control, based on the identifying of the abnormal battery cell, an operation of the vehicle.

2. The apparatus of claim **1,** wherein the processor is configured to obtain the one or more parameters **by:**

   identifying a discharging current that is output from the battery while controlling, based on a torque according to the status information, the motor;
   obtaining a first voltage corresponding to the discharging current; and
   obtaining, based on at least one of the discharging current or the first voltage, first parameters, of the one or more parameters, that indicate an internal series resistance associated with the discharging current.

3. The apparatus of claim **2,** wherein the processor is configured to obtain the one or more parameters further **by:**

   after the controlling of the motor based on the torque, transmitting, to the battery, a charging current obtained while controlling, based on a counter torque according to the status information, the motor;
   obtaining a second voltage corresponding to the charging current; and
   based on at least one of the discharging current, the charging current, the first voltage, or the second voltage, obtaining second parameters, of the one or more parameters, that indicate an internal series resistance associated with the charging current.

4. The apparatus of claim 3, wherein the processor is configured to identify the abnormal battery cell by:
   identifying, based on at least one of a standard deviation of the first parameters or a standard deviation of the second parameters, the parameter that exceeds the threshold value.

5. The apparatus of anyone of claims 2-4, wherein the processor is configured to obtain the first voltage by:

obtaining the first voltage that corresponds to a target value of the discharging current by increasing an amount of the discharging current.

6. The apparatus of claim 3 or 4, or of claim 5 provided that in combination with claim 3, wherein the processor is configured to obtain the second voltage by: obtaining the second voltage that corresponds to a target value of the charging current by increasing an amount of the charging current.

7. The apparatus of anyone of claims 2-6, wherein the processor is configured to obtain the first parameters by:

   obtaining a no-load voltage of the battery before controlling the motor in the no-load state; and obtaining the first parameters based on the discharging current, the first voltage, and the no-load voltage.

8. The apparatus of anyone of claims 1-7, wherein the processor is configured to obtain the one or more parameters by: obtaining the one or more parameters that correspond to a current target value by increasing a torque of the motor, wherein the increasing of the torque of the motor is performed by controlling the motor based on the status information.

9. The apparatus of anyone of claims 1-8, further comprising:

   a display,
   wherein the processor is further configured to display, on the display, information about the abnormal battery cell.

10. The apparatus of anyone of claims 1-9, wherein the processor is further configured to:

    before the receiving of the request for diagnosing the battery, obtain battery cell information of the battery; and
    determine whether the abnormal battery cell matches the battery cell information.

11. A method performed by an apparatus of a vehicle, the method comprising:

    disconnecting, based on receiving a request for diagnosing a battery of the vehicle, a motor of the vehicle from a drive shaft of the vehicle, wherein the battery comprises one or more battery cells;
    obtaining, based on controlling the motor according to status information of the battery in a no-load state where the motor is disconnected from the drive shaft, one or more parameters that indicate an internal series resistance of each of the one or more battery cells;
identifying an abnormal battery cell, of the one or more battery cells, corresponding to a parameter, of the one or more parameters, that exceeds a threshold value; and
controlling, based on the abnormal battery cell, an operation of the vehicle.

12. The method of claim 11, wherein the obtaining of the one or more parameters comprises:

    identifying a discharging current that is output from the battery while controlling, based on a torque according to the status information, the motor;
    obtaining a first voltage corresponding to the discharging current; and
    obtaining, based on at least one of the discharging current or the first voltage, first parameters, of the one or more parameters, that indicate an internal series resistance associated with the discharging current.

13. The method of claim 12, wherein the obtaining of the one or more parameters further comprises:

    after the controlling of the motor based on the torque, transmitting, to the battery, a charging current obtained while controlling, based on a counter torque according to the status information, the motor;
    obtaining a second voltage corresponding to the charging current; and
    based on at least one of the discharging current, the charging current, the first voltage, or the second voltage, obtaining second parameters, of the one or more parameters, that indicate an internal series resistance associated with the charging current.

14. The method of claim 13, wherein the identifying of the abnormal battery cell comprises:
    identifying, based on at least one of a standard deviation of the first parameters or a standard deviation of the second parameters, the parameter that exceeds the threshold value.

15. The method of anyone of claims 12-14, wherein the obtaining of the first voltage comprises:
    obtaining the first voltage that corresponds to a target value of the discharging current by increasing an amount of the discharging current.

VEHICLE CONTROL APPARATUS
100

| PROCESSOR 110 | | MEMORY 120 |
|---|---|---|
| MOTOR 130 | | PROFILE INFORMATION 121 |
| INVERTER 135 | | BATTERY CELL INFORMATION 122 |
| BATTERY 140 | | |
| DISPLAY 145 | | |

FIG.1A

FIG. 1B

START

IDENTIFY EXECUTION OF ABNORMAL DIAGNOSIS ~S210

BMU -> VCU REQUEST ~S220

EXECUTE DAS ~S230

VCU -> MCU REQUEST ~S240

DRIVE MOTOR ~S250

IDENTIFY INTERNAL SERIES RESISTANCE ~S260

DIAGNOSE ABNORMAL BATTERY CELL ~S270

END

FIG.2

```
┌─────────────────────────────────────────┐  ┌─ S210
│ IDENTIFY EXECUTION OF ABNORMAL DIAGNOSIS │◄─┐
└─────────────────────────────────────────┘  │
                    │                         │
                    ▼                         │
              ╱───────────╲     ┌─ S211        │
         ╱─── DETERMINE WHETHER ───╲  No       │
         AN ABNORMAL DIAGNOSTIC INPUT ─────────┤
         ╲───── IS IDENTIFIED? ────╱           │
              ╲───────────╱                    │
                    │ Yes                      │
                    ▼                          │
┌─────────────────────────────────────────┐  ┌─ S212
│      DETERMINE WHETHER ABNORMAL          │◄─┤
│         DIAGNOSIS IS POSSIBLE            │  │
└─────────────────────────────────────────┘  │
                    │                         │
                    ▼                         │
              ╱───────────╲                   │
         ╱──── INTERNAL ────╲   ┌─ S213        │
      TEMPERATURE DEVIATION OF            No   │
      BATTERY IS EQUAL TO OR LOWER ────────────┤
         ╲── THAN THRESHOLD ──╱                │
              TEMPERATURE?                     │
              ╲───────────╱                    │
                    │ Yes                      │
                    ▼                          │
┌─────────────────────────────────────────┐  ┌─ S220
│            BMU -> VCU REQUEST            │◄─┤
└─────────────────────────────────────────┘  │
                    │                         │
                    ▼                         │
              ╱───────────╲     ┌─ S221        │
         ╱─ SEPARATION OF DRIVE SHAFT ─╲  No   │
         ╲────── IS COMPLETED? ────────╱───────┘
              ╲───────────╱
                    │ Yes
                    ▼
┌─────────────────────────────────────────┐
│     IDENTIFY NO-LOAD VOLTAGE BEFORE      │─ S222
│     INITIATING DRIVING OF INVERTER       │
└─────────────────────────────────────────┘
```

FIG.3

```
              ┌─────────────────────────┐
              │     VCU -> MCU REQUEST   │──S240
              └─────────────────────────┘
                           │
                           ▼
                       ╱S241╲
                  ╱  PROFILE INFORMATION ╲  No    ┌──────────────────────────────────┐
                  ╲    IS IDENTIFIED?    ╱───────▶│ REQUEST PROFILE INFORMATION FROM BMU │──S242
                       ╲      ╱                    └──────────────────────────────────┘
                         │ Yes
                         ▼
              ┌─────────────────────────┐
              │       DRIVE MOTOR        │──S250
              └─────────────────────────┘
                           │
                           ▼
                       ╱S251╲
                  ╱   TORQUE REACHES  ╲   No      ┌──────────────────────┐
                  ╲  MAXIMUM TORQUE?  ╱──────────▶│   INCREASE TORQUE    │──S252
                       ╲      ╱                    └──────────────────────┘
                         │ Yes
                         ▼
              ┌─────────────────────────────────┐
              │ IDENTIFY VOLTAGE CORRESPONDING TO │──S253
              │   MAXIMUM DISCHARGING CURRENT     │
              └─────────────────────────────────┘
                           │
                           ▼
                       ╱S254╲
                  ╱ TORQUE REACHES MAXIMUM ╲ No   ┌──────────────────────────┐
                  ╲    COUNTER TORQUE?     ╱─────▶│ INCREASE COUNTER TORQUE  │──S255
                       ╲      ╱                    └──────────────────────────┘
                         │ Yes
                         ▼
              ┌─────────────────────────────────┐
              │ IDENTIFY VOLTAGE CORRESPONDING TO │──S256
              │    MAXIMUM CHARGING CURRENT       │
              └─────────────────────────────────┘
                           │
                           ▼
              ┌─────────────────────────┐
              │  STOP DRIVING OF MOTOR   │──S257
              └─────────────────────────┘
```

FIG.4

500   TORQUE(501) ———
      VVOLTAGE(502) — - —
      CURRENT(503) -------

510   520

505

FIG.5

IDENTIFY INTERNAL SERIES RESISTANCE — S260

IDENTIFY DISCHARGING SERIES RESISTANCE — S261

IDENTIFY CHARGING SERIES RESISTANCE — S262

FIG.6

FIG.7

A

STORE DATA ON AT LEAST ONE BATTERY CELL
DIAGNOSED AS ABNORMAL BATTERY CELL — S276

GUIDE ABNORMAL BATTERY CELL — S277

FIG.8

B

**S910** SERIES RESISTANCE ABNORMALITY DIAGNOSIS EXISTS WHILE DRIVING?

No → **S940** IDENTIFY SERIES RESISTANCE ABNORMAL BATTERY CELL NUMBER WHILE CHARGING

→ **S950** DETERMINE WHETHER SERIES RESISTANCE ABNORMAL BATTERY CELL MATCHES DISCHARGING SERIES RESISTANCE ABNORMAL BATTERY CELL DURING CHARGING

Yes → **S920** IDENTIFY SERIES RESISTANCE ABNORMAL BATTERY CELL NUMBER WHILE DRIVING

→ **S930** DETERMINE WHETHER SERIES RESISTANCE ABNORMAL BATTERY CELL MATCHES DISCHARGING SERIES RESISTANCE ABNORMAL BATTERY CELL DURING DRIVING

→ **S960** STORE RESULT

→ **S286** GUIDE ABNORMAL BATTERY CELL

FIG.9

DISCONNECT CONNECTION BETWEEN MOTOR AND DRIVE SHAFT IN RESPONSE TO INPUT FOR DIAGNOSING BATTERY ~S1010

OBTAIN PLURAL PARAMETERS REPRESENTING INTERNAL SERIES RESISTANCE FOR EACH OF PLURAL BATTERY CELLS INCLUDED IN BATTERY, BASED ON CONTROLLING MOTOR ACCORDING TO CURRENT OR POWER OUTPUT FROM BATTERY IN NO-LOAD STATE WHERE CONNECTION BETWEEN MOTOR AND DRIVE SHAFT IS DISCONNECTED ~S1020

DETERMINE AT LEAST ONE BATTERY CELL CORRESPONDING TO AT LEAST ONE PARAMETER EXCEEDING SPECIFIED THRESHOLD AMONG PLURAL PARAMETERS AS ABNORMAL BATTERY CELL ~S1030

FIG.10

1000

1300

1100

1400

MEMORY

1310          1320

ROM          RAM

PROCESSOR

USER INTERFACE
INPUT DEVICE

1500

USER INTERFACE
OUTPUT DEVICE

1200

1600          1700

STORAGE

NETWORK
INTERFACE

FIG.11

**EUROPEAN SEARCH REPORT**

Application Number

EP 25 17 2318

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 118 354 929 A (SUBARU CORP) 16 July 2024 (2024-07-16) * paragraphs [0028], [0029], [0030], [0036], [0081] - [0084]; figure 1 * ----- | 1-15 | INV. B60L3/00 B60L58/16 B60L15/20 |
| A | CN 104 411 531 B (BOSCH GMBH ROBERT; SAMSUNG SDI CO LTD) 3 May 2017 (2017-05-03) * the whole document * ----- | 1-15 | |

TECHNICAL FIELDS SEARCHED (IPC)

B60L

The present search report has been drawn up for all claims

| Place of search | Date of completion of the search | Examiner |
|---|---|---|
| The Hague | 10 October 2025 | Bellatalla, Filippo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 2318

This annex lists the patent family members relating to the patent documents cited in the above-mentioned European search report.
The members are as contained in the European Patent Office EDP file on
The European Patent Office is in no way liable for these particulars which are merely given for the purpose of information.

10-10-2025

| Patent document cited in search report | | Publication date | Patent family member(s) | | Publication date |
|---|---|---|---|---|---|
| CN 118354929 | A | 16-07-2024 | CN | 118354929 A | 16-07-2024 |
| | | | JP | 7712487 B2 | 23-07-2025 |
| | | | JP | WO2024105801 A1 | 23-05-2024 |
| | | | US | 2024399925 A1 | 05-12-2024 |
| | | | WO | 2024105801 A1 | 23-05-2024 |
| CN 104411531 | B | 03-05-2017 | CN | 104411531 A | 11-03-2015 |
| | | | DE | 102012210908 A1 | 02-01-2014 |
| | | | EP | 2867055 A1 | 06-05-2015 |
| | | | WO | 2014001117 A1 | 03-01-2014 |

**REFERENCES CITED IN THE DESCRIPTION**

**Patent documents cited in the description**

- KR 1020240111412